(19) Europäisches Patentamt
European Patent Office
Office européen des brevets

(11) **EP 2 635 996 B1**

(12) **EUROPÄISCHE PATENTSCHRIFT**

(45) Veröffentlichungstag und Bekanntmachung des Hinweises auf die Patenterteilung:
**08.11.2017 Patentblatt 2017/45**

(51) Int Cl.:
***G06K 7/08*** *(2006.01)*      ***G06K 19/067*** *(2006.01)*

(21) Anmeldenummer: **11757664.5**

(22) Anmeldetag: **20.09.2011**

(86) Internationale Anmeldenummer:
**PCT/EP2011/066337**

(87) Internationale Veröffentlichungsnummer:
**WO 2012/038434 (29.03.2012 Gazette 2012/13)**

(54) **INFORMATIONSTRÄGER UND SYSTEM ZUR ERFASSUNG VON INFORMATIONEN**

INFORMATION CARRIER AND SYSTEM FOR ACQUIRING INFORMATION

SUPPORT D'INFORMATIONS ET SYSTÈME POUR DÉTECTER DES INFORMATIONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.09.2010 US 384478 P**

(43) Veröffentlichungstag der Anmeldung:
**11.09.2013 Patentblatt 2013/37**

(73) Patentinhaber: **T-Touch International S.à r.l.**
**1857 Luxembourg (LU)**

(72) Erfinder:
• **FÖRSTER, Matthias**
**01307 Dresden (DE)**
• **KREUTZER, André**
**09648 Mittweida (DE)**
• **THIELE, Jan**
**09127 Chemnitz (DE)**
• **VOIGT, Sascha**
**09337 Bernsdorf (DE)**
• **FRANZ, Thoralt**
**08297 Zwönitz/Brünlos (DE)**

(74) Vertreter: **Hertin und Partner**
**Rechts- und Patentanwälte PartG mbB**
**Kurfürstendamm 54/55**
**10707 Berlin (DE)**

(56) Entgegenhaltungen:
**EP-A1- 2 088 532     WO-A1-2010/043422**
**GB-A- 2 436 636**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung beschreibt einen kapazitiven Informationsträger, bei dem auf einem elektrisch nicht leitfähigen Substrat mindestens eine elektrisch leitfähige Touch-Struktur angeordnet ist. Weiterhin umfasst die Erfindung ein System und Verfahren zur Erfassung von Informationen bestehend aus einem kapazitiven Informationsträger, einem kapazitiven Flächensensor, einem Kontakt zwischen beiden Elementen und einer Wechselwirkung, welche die Touch-Struktur des Informationsträgers für ein mit dem Flächensensor verbundenes Datenverarbeitungssystem auswertbar macht und mit dem Informationsträger assoziierte Ereignisse auslösen kann.

Im Sinne der Erfindung ist ein Informationsträger insbesondere ein Medium zum Speichern, Abbilden, Hinterlegen und/oder Zuordnen von Informationen.

Im Sinne der Erfindung ist ein kapazitiver Flächensensor insbesondere eine physikalische Schnittstelle zur Erfassung von elektrischen Kapazitäten und/oder Kapazitätsunterschieden innerhalb von Teilbereichen einer definierten Fläche. Flächensensoren beinhaltende Geräte umfassen beispielsweise Smartphones, Handys, Displays, Tablet-PCs, Tablet-Notebooks, Touchpad-Geräte, Grafiktabletts, Fernseher, PDAs, MP3-Player, Trackpads und/oder kapazitive Eingabegeräte. Ein solcher Flächensensor kann beispielsweise auch Bestandteil von Eingabegeräten als Touchscreen, Touchpad oder Grafiktablett sein. Touchscreens sind auch als Tastschirm oder Sensorbildschirm bekannt. Derartige Eingabegeräte werden unter anderem in Smartphones, PDAs, Touchdisplays oder Notebooks eingesetzt.

Bekannte Lesegeräte oder Apparate zum Erfassen und Lesen von kapazitiven Informationen stellen einzelne Geräte dar, welche diese und nur genau diese Bestimmung haben. Nachteile der im Stand der Technik offenbarten Lesegeräten oder Apparate sind, dass für die einzelnen Anwendungen immer eigenständige kapazitive Lesegeräte verfügbar sein müssen und diese oft über eine Schnittstelle mit Daten verarbeitenden Medien verbunden sind. Die Verbreitung und Akzeptanz der Lesegeräte ist dadurch relativ schlecht und mit Mehrkosten durch die Anschaffung der Lesegeräte verbunden. Zudem ist die Verknüpfung real gedruckter Informationen mit digitalen Informationen sehr schlecht realisierbar. Eine Möglichkeit stellen Barcodes dar, welche mittels geeigneten Scannern oder Kameras erfasst werden und digitale Inhalte aufrufen können. Nachteilig bei den bekannten Barcodes ist, dass sie mit den systemtypischen Handicaps verbunden sind und z. B.: Informationen beliebig oft kopierbar sind, optisch Platz auf Produkten oder Werbeträgern einnehmen, schlecht in ausreichend guter Qualität individualisierbar sind, es einer direkten Sichtverbindung zwischen Code und Erfassungseinheit bedarf, welche durch Schmutz, Kratzer, Lichtverhältnisse etc. eine korrekte Erfassung und Auslesung der Information erschweren oder komplett verhindern. Bisherige bekannte kapazitive Datenträger überbrücken innerhalb eines Lesegerätes immer zwischen (mindestens) einer Lese- und einer Empfangselektrode. Abhängig vom Vorhandensein oder Nichtvorhandensein einer kapazitiven Struktur wird eine logische "1" bzw. "0" erkannt.

Der Stand der Technik zeigt mehrere Möglichkeiten auf, mittels Drucktechniken oder anderen Beschichtungsverfahren Informationsträger herzustellen, welche mittels geeignetem Leseverfahren bzw. Lesegerät ausgelesen werden können (z. B. US 3,719,804). Die wohl am meisten verbreiteten derart hergestellten Informationsträger sind Barcodes in der Ausführung als eindimensionaler Strichcode oder beispielsweise als zweidimensionale Varianten. Diese werden mit geeigneten optischen Scannern erfasst und gegebenenfalls über entsprechende Datenverarbeitungssysteme weiterverarbeitet.

Die Drucktechniken und Beschichtungstechniken zur Herstellung solcher Merkmale entwickeln sich ebenso weiter. So beschreibt die EP 1 803 562 ein Verfahren zum Transfer von bildgebenden Schichten von einer Trägerfolie bzw. Transferfolie auf Druckbogen in einer bogenverarbeitenden Maschine. Dabei wird in einem ersten Auftragswerk ein Kleber aufgebracht und in einem weiteren Beschichtungswerk mit einer Transferfolie zusammengefahren und Material von der Transferfolie durch Anhaftung auf die Druckbogen aufgebracht. Dabei wird in dem Beschichtungswerk ein Transferspalt gebildet und die Transferfolie an der Oberfläche einer Presswalze entlang mit der mit Transfermaterial beschichteten Seite auf einem Druckbogen aufgelegt und unter Druck gemeinsam mit diesem durch den Transferspalt geführt, so dass die bildgebenden Schichten in mit Kleber versehenen Bereichen von der Trägerfolie auf den Druckbogen haftend übertragen werden. Damit können ohne weiteres Barcodes und alphanumerische Informationen aufgebracht werden.

Im Stand der Technik werden weiterhin in US 5,818,019, US 3,719,804, US 4,587,410 und US 2006/0118612 flächige gedruckte Materialien offenbart, die eine sichere Verifikation oder Validierung von Daten erlauben. Dies kann beispielsweise für Medikamente und ihre Verpackungen, aber auch für Lotterielose sinnvoll sein. Die aufgedruckten Informationen stellen z. B. die Authentifizierung sicher oder dienen der Gültigkeitsprüfung. Auch kapazitiv auslesbare Informationsträger sind u. a. aus den Anmeldungen US 3,719,804 (permanenter Informationsspeicher) und US 4,587,410 (Parksystem) bekannt. Im letztgenannten Beispiel ist die Bearbeitung und Veränderbarkeit von kapazitiven Strukturen für ein Parkmeter dargestellt. Mittels mechanischer Einheit wird die kapazitive Struktur im Lesegerät sukzessive verändert und so ihr "innerer Wert" verändert. Eine Individualisierung der Strukturen ist nicht vorgesehen. Das komplette System ist ein autarkes System ohne Interaktion zu anderen Systemen oder einer Datenverarbeitung bzw. Datenspeicherung. In US 3,719,804 sind die Herstellmöglichkeiten mittels Drucktechniken wie beispielsweise Siebdruck, Flexodruck und Tiefdruck aufgeführt. Die Beschreibung bezieht sich auf flüssig prozessierbare Materialien, welche sich für Druckprozesse eignen. Dies ist mit allen Problemen behaftet, die solche flüssig prozessierbaren Tinten mit sich bringen. Die Tinten, die dem genügen, sind sehr teuer, beinhalten Lösemittel, sind begrenzt haltbar und verursachen prozesstechnische Probleme. Die Individualisierung erfolgt mittels Trenntechniken der aufgebrachten Leiterzüge. Das Ausleseverfahren ist stark positionsabhängig und ist mit einer festen Ausleseposition des Informationsträgers im Lesegerät verbunden.

Zusammenfassend weisen die im Stand der Technik vorgeschlagenen Lösungen für Informationsträger mehrere Nachteile auf. Sie sind beispielsweise für die Massenanwendung nicht preiswert genug, können aufgrund ihres komplexen Aufbaus nur unvollkommen recycelt werden (RFID-Systeme), sind mitunter leicht kopierbar (Barcodes), erzeugen hohen Aufwand durch Anbringung auf das Endprodukt oder lassen sich nur schlecht oder gar nicht drucktechnisch weiterverarbeiten (Chipkarten).

Ausgehend von diesem Stand der Technik ist es die Aufgabe der vorliegenden Erfindung, einen einfach zu realisierenden kapazitiven Informationsträger für einen kapazitiven Flächensensor zum Auslösen wenigstens eines Ereignisses zu schaffen.

Ein Ereignis bezeichnet im Sinne der Erfindung insbesondere das, was eine Aktion und damit eine Zustandsveränderung, bevorzugt innerhalb von Anwendungen, auslöst. Diese Ereignisse können beispielsweise Benutzereingaben oder Systemereignisse sein. Die Ereignisse werden bevorzugt auf Geräten ausgelöst, welche selbst den Flächensensor tragen, beispielsweise Smartphones, Handys, Displays, Tablet-PCs, Tablet-Notebooks, Touchpad-Geräte, Grafiktabletts, Fernseher, MP3 Player, Trackpads und kapazitive Eingabegeräte, ohne darauf begrenzt zu sein.

Die Aufgabe wird durch die unabhängigen Ansprüche gelöst. Bevorzugte Ausführungsformen der Erfindung ergeben sich aus den Unteransprüchen.

Es war völlig überraschend, dass mit den erfindungsgemäßen kapazitiven Informationsträgern, dem erfindungsgemäßen System sowie der Verwendung von Informationsträgern und -systemen und durch das erfindungsgemäße Verfahren zur Erfassung von Informationen die Nachteile des Standes der Technik überwunden werden konnten.

Es wird mithin ein kapazitiver Informationsträger bereitgestellt, bei dem auf einem elektrisch nicht leitfähigen Substrat mindestens eine elektrisch leitfähige Schicht als Touch-Struktur angeordnet ist. Die Touch-Struktur umfasst bevorzugt mindestens einen Touch-Punkt, eine Koppelfläche und/oder eine Leiterbahn.

Eine Koppelfläche ist im Sinne der Erfindung insbesondere ein elektrisch leitfähiger Bereich auf dem Substrat. Die Koppelfläche stellt eine bevorzugte Variante des erfindungsgemäßen Informationsträgers dar, welche es beispielsweise ermöglicht, elektrische Fremdkapazitäten, welche nicht Bestandteil der Touch-Struktur sind, anzukoppeln und damit die wirksame elektrische Kapazität der Touch-Struktur des Informationsträgers zu erhöhen. Dadurch können die Informationsträger besonders sicher und zuverlässig ausgelesen werden. Das kann sowohl durch Berührung oder Annäherung einer Person als auch Kopplung durch einen Gegenstand erfolgen.

Leiterbahnen bestehen bevorzugt aus einer elektrisch leitfähigen Schicht und stellen bevorzugt eine elektrische Verbindung zwischen zwei oder mehreren Teilbereichen her.

Vorteilhafterweise besteht das Substrat in einer bevorzugten Ausführungsform aus einem Kunststoff, einem Papier, einem Karton, einem Holzwerkstoff, einem Verbundwerkstoff, Glas, Keramik, Textilien, Leder oder einer Kombination davon. Das Substrat ist insbesondere ein elektrisch nicht leitfähiger Stoff, der vorzugsweise flexibel ist und ein geringes Gewicht aufweist. Es können lichtdurchlässige oder lichtundurchlässige Substrate verwendet werden. Bevorzugte Kunststoffe umfassen insbesondere PVC, PETG, PV, PETX, PE und synthetische Papiere.

Es ist bevorzugt, dass die elektrisch leitfähige Schicht eine Metallschicht, eine Metallpartikel enthaltene Schicht, eine elektrisch leitfähige Partikel enthaltene Schicht, elektrisch leitfähige Polymerschicht oder eine Schicht aus wenigstens einer Kombination dieser Schichten ist. Elektrisch leitfähige Partikel sind dabei insbesondere Ruß- oder Graphitpartikel. Polymere bezeichnen im Sinne der Erfindung insbesondere eine Substanz, die sich aus einem Kollektiv chemisch einheitlich aufgebauter, sich in der Regel aber hinsichtlich Polymerisationsgrad, Molmasse und Kettenlänge unterscheidender Makromoleküle (Polymermoleküle) zusammensetzt. Die Polymere sind vorzugsweise elektrisch leitfähig. Bei solchen polymereinheitlichen Stoffen sind alle Makromoleküle bevorzugt gleich aufgebaut und unterscheiden sich lediglich durch ihre Kettenlänge (Polymerisationsgrad). Man kann derartige Polymere als Polymerhomologe bezeichnen. Polymere können aus der Gruppe umfassend anorganische Polymere, metallorganische Polymere voll- oder teilaromatische Polymere, Homopolymere, Copolymere, Biopolymere, chemisch modifizierte Polymere und/oder synthetische Polymere ausgewählt werden. Besonders bevorzugt sind Polymere ausgewählt aus Paraphenylen, Polyacetylen, Polypyrrol, Polythiophen, Polyanilin (PANI) und PE-DOT. Somit ist der Informationsträger kostengünstig mittels eines Massenherstellungsverfahren herstellbar.

Erfindungsgemäß ist eine Touch-Struktur insbesondere eine strukturiert aufgebrachte Schicht aus leitfähigem Material. Durch die erfindungsgemäße Verknüpfung dieser beiden Eigenschaften, elektrische Leitfähigkeit und Struktur, ist es überraschenderweise gelungen, eine gezielte Wechselwirkung der Touch-Struktur mit kapazitiv wirksamen Bereichen zu erreichen.

Da Touch-Punkt, Leiterbahn und Koppelfläche bevorzugt aus dem gleichen oder ähnlichen elektrisch leitfähigen Materialien bestehen können, kann ein Informationsträger vorzugsweise durch die Anwendung lediglich eines technologischen Verfahrens hergestellt werden. Dadurch sind die Informationsträger als Massenprodukt leicht und ökonomisch realisierbar. In einer bevorzugten Ausführungsform der Erfindung kann es vorgesehen sein, dass auf dem Substrat eine Touch-Struktur mit mindestens einer Koppelfläche angeordnet ist, welche vorzugsweise mit mindestens einem Touch-Punkt über mindestens eine Leiterbahn verbunden ist und/oder Teil des Touch-Punkts eine Koppelfläche ist.

Die Touch Struktur kann im Sinne der Erfindung insbesondere als Signatur oder Signet bezeichnet werden. Durch die erfindungsgemäße Verknüpfung dieser beiden Eigenschaften, elektrische Leitfähigkeit und Struktur, ist es überraschenderweise gelungen eine gezielte Wechselwirkung der Touch-Struktur mit kapazitiven wirksamen Bereichen eines Flächensensors zu erreichen. Damit wird die Struktur der Touch-Struktur für ein, mit dem Flächensensor verbundenem Datenverarbeitungssystem auswertbar. Vorteilhafterweise kann die aufgebrachte Touch-Struktur bereichsweise, mittels additiver und/oder subtraktiver Verfahren, bevorzugt durch Inkjetverfahren und besonders bevorzugt durch Laserverfahren in ihrer Strukturierung veränderbar sein.

In einer bevorzugten Ausführungsform ist die Touch Struktur eine gedruckte Schicht auf dem Substrat. Es war völlig überraschend, dass die Touch Struktur mittels eines Druckverfahrens auf ein Substrat aufbringbar ist. Es ist bevorzugt, dass der Informationsträger mittels einem, dem Fachmann bekannten Druckverfahren, bevorzugt einem additiven und/oder subtraktiven Verfahren hergestellt wird. Dies stellt einen erheblichen Vorteil gegenüber dem Stand der Technik dar, da der Informationsträger hierdurch in Massenherstellungsverfahren herstellbar ist. Die Touch Struktur ist vorteilhafterweise mit einem Additiv- oder Subtraktivverfahren leicht und ökonomisch günstig realisierbar.

Es ist jedoch auch bevorzugt, dass die Touch Struktur mittels eines Transferverfahrens auf das Substrat übertragen wird. Bevorzugt kann das Aufbringen der Touch Struktur auf dem Substrat durch an sich bekannte Transferverfahren erfolgen; bevorzugt handelt es sich hierbei um das Transferfolienverfahren und besonders bevorzugt um ein Kaltfolientransferverfahren. Dem Fachmann sind derartige Verfahren bekannt und er weiß, dass es möglich ist, mittels Druckverfahren eine Substanz (wie z.B. eine Touch Struktur) strukturiert, insbesondere bereichsweise auf dem Substrat aufzubringen. Hierbei wird das Substrat nicht vollflächig durch die Touch Struktur bedeckt, sondern die Touch Struktur liegt lediglich auf bestimmten Bereichen des Substrats vor. Selbstverständlich können auch andere Verfahren zur strukturierten Aufbringung einer Schicht verwendet werden.

Weiterhin wird ein kapazitiver Informationsträger bereitgestellt, der durch ein Transferfolienverfahren hergestellt ist und das Verfahren folgende Schritte umfasst:

a. Bereitstellung einer Transferfolie auf einer Rolle, wobei die Transferfolie eine Trägerfolie und eine zumindest bereichsweise darauf befindliche elektrisch leitfähige Transferschicht umfasst,

b. Bereitstellung eines elektrisch nicht leitfähigen Substrates,

c. Bereitstellung eines Klebers,

d. strukturierte Aufbringung des Klebers gemäß c) auf das Substrat und/oder auf die Transferfolie,

wobei auf dem elektrisch nicht leitfähigen Substrat mindestens bereichsweise eine elektrisch leitfähige Schicht als Touch-Struktur angeordnet ist. Es ist bevorzugt, dass mindestens die Touch-Struktur mit einer weiteren Schicht bedeckt ist.

Der Informationsträger umfasst vorzugsweise ein elektrisch nicht leitfähiges Substrat, auf das wenigstens bereichsweise ein Kleber aufgebracht wird und eine dazu durch Haftung am Kleber deckungsgleich aufgebrachte, mindestens einlagige elektrisch leitfähige Schicht, wobei Kleber und elektrisch leitfähige Schicht durch ein Transferverfahren, bevorzugt durch ein Transferfolienverfahren und besonders bevorzugt durch ein Kaltfolientransferverfahren aufgebrachte Schichten sind und die elektrisch leitfähige Schicht als Touch-Struktur ausgestaltet ist und mindestens die Touch-Struktur mit einer weiteren Schicht bedeckt ist.

Die Strukturierung der elektrisch leitfähigen Schicht erfolgt insbesondere über den Kleber, der bevorzugt ein elektrisch leitfähiger Kleber ist. Es ist bevorzugt, dass der Kleber in einer Anordnung bzw. Layout direkt auf das Substrat (Bedruckstoff) aufgebracht und anschließend in Kontakt mit der Transferfolie geführt wird. Vorteilhafter Weise können sowohl der Kleberauftrag als auch das Zusammenfahren des Substrates mit der Transferfolie in einer Maschine erfolgen. Die Transferfolie selbst besteht aus mindestens zwei Schichten, einer transferierbaren Schicht (=Transferschicht) und einem weiteren Trägermaterial (der Trägerfolie), welches diese Schicht trägt. Die Verbindung der zwei Schichten ist so ausgebildet, dass eine Übertragung der Transferschicht mittels des Klebers auf das Substrat gut möglich ist, demnach also das Adhäsionsvermögen des Klebers zu Substrat und Transferschicht höher sein muss als das Kohäsionsvermögen der Transferschicht und das Adhäsionsvermögen der Transferschicht auf dem Trägermaterial. Ist der Materialübertrag erfolgt, enthält das Substratmaterial sowohl den strukturiert aufgebrachten Kleber als auch diesen gleichermaßen deckend das Transfermaterial als Transferschicht, welches nun ebenfalls strukturiert ist. Dies kann zudem durch Zuhilfenahme von Druck, Temperatur, mechanischen Hilfsmitteln wie Prägestempel, Kontaktpressungen etc. unterstützt werden. Es kann so ein Informationsträger bereitgestellt werden, der aufgrund seines Layouts und der materiellen Eigenschaften des Transfermaterials eine kapazitive auslesbare Struktur ergibt, welche in einem geeigneten Lesegerät bestimmt werden oder einem Flächensensor interagieren kann. Es ist bevorzugt, dass mindestens die Touch-Struktur ausbildende Schicht wenigstens bereichsweise mit einer weiteren Schicht bedeckt ist, wobei die Schicht vorzugsweise eine Papierschicht, eine Folienschicht, eine Farbschicht, eine Lackschicht und/oder Kombinationen derer ist. Die weitere Schicht kann im Sinne der Erfindung auch als Deckschicht bezeichnet werden. Die Deckschicht kann vorteilhafterweise als Schutz oder Unkenntlichmachung der Touch-Struktur des Informationsträgers verwendet werden. In einer bevorzugten Variante kann diese Deckschicht auch als Deckplatte ausgeführt sein. Die Deckplatte kann aus starren oder flexiblen Materialien bestehen.

In einer weiteren bevorzugten Ausführungsform ist auf einem elektrisch nicht leitfähigen Substrat mindestens eine elektrisch leitfähige, die Anordnung und/oder Eigenschaften von Fingerkuppen nachbildende, Touch-Struktur angeordnet. Die zusätzliche Eigenschaft der Touch-Struktur, die Anordnung und/oder Eigenschaften von Fingerkuppen nachzubilden, ist dabei besonders vorteilhaft, weil eine solche Struktur für ein mit dem Flächensensor verbundenes Datenverarbeitungssystem einfach auswertbar und besser softwaretechnisch zu verarbeiten ist.

Ein kapazitiver Flächensensor kann im Sinne der Erfindung insbesondere als ein Touchscreen bezeichnet werden.

Im Stand der Technik umfasst ein solcher Touchscreen insbesondere einen aktiven Schaltkreis, den Touch-Controller, welcher mit einer Struktur von Elektroden verbunden ist. Diese Elektroden sind in der Regel aufgeteilt in Sende- und Empfangselektroden. Der Touch-Controller steuert die Elektroden vorzugsweise so an, dass zwischen jeweils einer oder mehreren Sendeelektroden und einer oder mehreren Empfangselektroden ein Signal übertragen wird. Im Ruhezustand des Touchscreens bleibt das Signal beispielsweise konstant. Der im Stand der Technik beschriebene Zweck eines Touchscreens ist insbesondere das Detektieren von Fingern und deren Position auf der Oberfläche des Touchscreens. Hierzu bewirkt das Einbringen eines Fingers, dass das Signal zwischen den Elektroden verändert wird. In der Regel wird das Signal vermindert, weil der eingebrachte Finger einen Teil des Signals von der Sendeelektrode aufnimmt und so ein geringeres Signal an der Empfangselektrode ankommt.

Eine vorteilhafte Eigenschaft der Touch-Struktur ist deren Leitfähigkeit. Wird anstelle eines Fingers ein bevorzugter Informationsträger mit der Touch-Struktur mit einem Flächensensor in Kontakt gebracht, so bewirken die leitfähigen Bereiche bevorzugt denselben Effekt wie ein Finger. Allerdings ist die leitfähige Struktur bereichsweise strukturiert, da einerseits an bestimmten Stellen, insbesondere den Touch-Punkten der Effekt, welcher mit dem Einbringen eines Fingers vergleichbar ist, maximiert werden soll, um für den Touch-Controller bestmöglich erkennbar zu sein. Damit wird die Touch-Struktur vorteilhafterweise für ein mit dem Flächensensor verbundenes Datenverarbeitungssystem auswertbar.

In einer weiteren bevorzugten Ausführungsform ist auf einem elektrisch nicht leitfähigen Substrat mindestens eine elektrisch leitfähige, die Anordnung und/oder Eigenschaften von Fingerkuppen nachbildende, Touch-Struktur angeordnet. Die Touch-Struktur umfasst mindestens einen Touch-Punkt, eine Leiterbahn und/oder eine Koppelfläche. Es ist bevorzugt, dass die Kombination von wenigstens einem oder mehreren Touch-Punkten in einer Touch-Struktur die Anordnung und/oder Eigenschaften von Fingerkuppen nachbildet. Im Sinne der Erfindung kann mit der Touch-Struktur, bevorzugt mindestens einer Koppelfläche, besonders bevorzugt mindestens einer Leiterbahn und ganz besonders bevorzugt mindestens einem Touch-Punkt, ähnlich wie mit einem Finger, eine Eingabe auf einem Flächensensor ausgeführt werden. Aus diesem Grund kann die bevorzugte Ausführungsform der Erfindung dadurch beschrieben werden, dass die Touch-Struktur die Eigenschaften von Fingerkuppen nachbilden, wobei hiermit vorzugsweise die Eigenschaft der Touch-Struktur bezeichnet ist, dass diese ebenso wie ein Finger eine Eingabe auf einem Flächensensor vornehmen kann. Diese zusätzliche Eigenschaft der Touch-Struktur, die Anordnung und/oder Eigenschaften von Fingerkuppen nachzubilden, ist dabei besonders vorteilhaft, weil eine solche Struktur für ein mit dem Flächensensor verbundenes Datenverarbeitungssystem einfach auswertbar und besser softwaretechnisch zu verarbeiten ist.

Dabei bildet ein Touch-Punkt, durch eine Strukturierung des leitfähigen Bereichs auf dem Informationsträger, in geeigneter Weise die Eigenschaften von Fingerkuppen nach. Einem Fachmann ist bekannt, dass auf einem Touchscreen oder einem Flächensensor eine Eingabe mittels einem oder mehrerer Finger vorgenommen werden kann (Single- oder Multi-Touch). Die Technologie der Flächensensoren und die Prinzipien der Eingabe, bzw. durch welche Eigenschaften eines Fingers eine Eingabe erfolgt, sind dem Fachmann ebenfalls bekannt. Beispielsweise können neben den elektrischen Eigenschaften des Fingers (z. B. Leitfähigkeit) auch Dichte, Druck der Eingabe oder Entfernung zum Flächensensor die Eingabe beeinflussen. Das bevorzugte System erreicht durch die Strukturierung des leitfähigen Bereichs die gleiche Wirkung auf einem Flächensensor wie ein Finger, nämlich eine Eingabe an einer, durch die leitfähigen Bereiche des Informationsträgers definierten Position auf dem Flächensensor. Der Fachmann könnte somit ohne großen experimentellen Aufwand die Touch-Struktur des Informationsträgers derart ausführen, dass die Eigenschaften von Fingern, bzw. Fingerkuppen nachgebildet werden und mit den elektrisch leitfähigen Flächen des Informationsträgers eine Eingabe auf einem Flächensensor erzielt werden kann.

In einem Beispiel, ohne darauf beschränkt zu sein, von einem bevorzugten Informationsträger in Wechselwirkung mit einem sogenannten Touchscreen mit einer Elektrodenanordnung in Form eines Gitters, ist beispielsweise eine

geeignete Strukturierung des Touch-Punktes ein Kreis mit einem Durchmesser von 1 bis 20 mm, bevorzugt 4 bis 15 mm und besonders bevorzugt 6 bis 10 mm. Da ein Touchscreen geeignet ist, um die Position von Fingerkuppen zu bestimmen, ist ein Touch-Punkt eines Informationsträgers ebenfalls in gleicher Weise vom Touchscreen bestimmbar. Der Touchscreen oder Flächensensor kann vorteilhafterweise nicht unterscheiden, ob die Eingabe durch die Touch-Struktur eines Informationsträgers oder durch einen Finger erfolgte.

Es kann bevorzugt sein, auf dem erfindungsgemäßen Informationsträger mehrere Touch-Strukturen aufzubringen. Vorteilhafterweise können Form, Orientierung, Anzahl, Ausrichtung, Abstand und/oder Position von Teilbereichen der Touch-Struktur zur Speicherung einer Information genutzt werden.

Günstigerweise ist nach einer weiteren bevorzugten Ausführungsform das elektrisch leitfähige Material eine gedruckte Schicht auf dem Substrat. Die Schicht ist damit mit einem Additivverfahren leicht und ökonomisch günstig realisierbar. Dem Fachmann sind derartige Verfahren bekannt. Selbstverständlich können auch alle anderen Verfahren zur strukturierten Aufbringung einer elektrisch leitfähigen Schicht verwendet werden.

Die elektrisch leitfähige Schicht ist nach einer weiteren bevorzugten Ausführungsform durch Anwendung eines Subtraktivverfahrens realisiert, wobei Schichtbereiche abgetragen sind. Dabei kommen bekannte Ätz- oder Laserabtragverfahren zum Einsatz. Bei letzteren wird das abzutragende Material durch das Wirken der Laserstrahlen verdampft. Selbstverständlich können auch weitere Verfahren eingesetzt werden.

Es war völlig überraschend, dass der Informationsträger oder eine Gruppe von Informationsträgern und/oder das erfindungsgemäße System in zahlreichen Bereichen des Wirtschaftslebens verwendet werden können. Diese umfassen beispielsweise Spielkarten, Sammelkarten, Briefmarken, Frankierung, Porto, Warenlogistik, Warenverfolgung, Einlass, Eintrittskarten, Zugang zu geschlossen Bereichen, virtuellen Inhalten, Marketinganwendungen, Kundenbindung, Lotterie- und Gewinnspielen, Mitgliederausweise, Zeitkarten, Bezahlanwendungen, Echtheits-Zertifikate, Zertifikate, Fälschungssicherungen, Kopierschutze, Signaturen, Lieferscheine, Kontoauszüge, Beipackzettel, Gegenstände innerhalb von Computerspielen, Music/Video/E-Books-Downloads, Bonusmarken/-programme, Gerätesteuerungen oder Geschenkkarten, ohne darauf begrenzt zu sein.

Es kann auch bevorzugt sein, dass der Informationsträger mit einem Gegenstand verbunden ist oder der Gegenstand selbst als Substrat dient. Als Gegenstand wird im Sinne der Erfindung insbesondere ein Ding, eine Sache oder ein Objekt bezeichnet. Ein Gegenstand ist bevorzugt ausgewählt aus der Gruppe umfassend eine Verpackung, Geschirr, Druckerzeugnisse, Kleidung, Möbel, Dokumente, Spielzeug, Konsumartikel, Lebensmittel, Halbzeuge, Maschinenteile, Baustoffe, Ein- und Mehrwegbehältnisse und/oder elektrische Geräte. Prinzipiell können auch nicht flächig ausgebildete Gegenstände direkter Träger eines Informationsträgers sein (Gegenstand übernimmt Substratfunktion) oder auch indirekt, indem der Informationsträger an dem Gegenstand angebracht oder aufgebracht sein kann. Die An- oder Aufbringung kann beispielsweise selbstklebend oder mittels anderer bekannter Verbindungstechnologien oder Hilfsstoffe erfolgen, beispielsweise ein Label an Textilien.

Vorteilhafterweise ist mindestens ein Informationsträger mit mindestens einem Flächensensor mindestens bereichsweise in Kontakt. Dazu befindet sich auf einem Substrat mindestens eine bereichsweise aufgebrachte elektrisch leitfähige Schicht, wobei wenigstens ein Bereich der elektrisch leitfähigen Schicht ein Teilbereich ist. Der oder die Teilbereich(e) werden im Sinne der Erfindung auch als Touch-Struktur bezeichnet. Die Form, Orientierung, Anzahl, Ausrichtung, Abstand und/oder Position der Touch-Struktur oder deren Teilbereiche bilden bevorzugt die Information, so dass bei mindestens bereichsweiser Positionierung des Informationsträgers an dem Flächensensor oder über eine relative Bewegung wenigstens eines Bereiches des Informationsträgers gegenüber dem Flächensensor wenigstens ein Ereignis ausgelöst wird. Eine bereichsweise Positionierung des Informationsträgers auf dem Flächensensor bedeutet im Sinne der Erfindung, dass insbesondere mindestens ein Bereich des Informationsträgers mit mindestens einem Bereich des Flächensensors in Kontakt steht.

Der Informationsträger wird bevorzugt derart mit dem Flächensensor in Kontakt gebracht, dass durch den Flächensensor mindestens ein Ereignis ausgelöst wird.

Im Sinne der Erfindung bedeutet in Kontakt bringen, dass insbesondere zwischen dem Informationsträger und dem Flächensensor bevorzugt kein Freiraum besteht. Das heißt, der Informationsträger ist bevorzugt mit dem Flächensensor in Berührungskontakt. Es kann jedoch auch bevorzugt sein, dass zwischen dem Informationsträger und dem Flächensensor kein direkter Kontakt besteht, sondern bereits eine Annäherung ausreicht, um ein Ereignis auszulösen. Bei einer Annäherung besteht zwischen Informationsträger und Flächensensor ein bevorzugter Abstand von größer 0 cm bis 2 cm.

Demgemäß betrifft die Erfindung auch ein System, umfassend mindestens einen kapazitiven Informationsträger und mindestens einen kapazitiven Flächensensor, wobei zwischen dem Informationsträger und dem Flächensensor ein Kontakt oder Annäherung erfolgt und hierdurch eine kapazitive Wechselwirkung erreicht wird. Durch die kapazitive Wechselwirkung wird die Touch-Struktur des Informationsträgers für ein mit dem Flächensensor verbundenes Datenverarbeitungssystem auswertbar und kann dadurch mit dem Informationsträger assoziierte Ereignisse auslösen. Im Sinne der Erfindung bezeichnet ein Flächensensor auch einen Berührungsbildschirm.

Durch diese kapazitive Wechselwirkung kann bevorzugt ein Ereignis auf dem den Flächensensor tragenden Gerät ausgelöst werden. Das Ereignis löst wiederum Aktionen aus, wie beispielsweise die Aktivierung und/oder Beenden einer Anwendung (eines Programms), das Verändern von numerischen Werten und/oder Texten, das Manipulieren von Grafiken, das Verändern von Datenbeständen oder das Erlangen von Zugriff auf informationstechnische Dienste ohne darauf beschränkt zu sein.

Bevorzugt ist, dass der Flächensensor mindestens ein kapazitives Display umfasst und das den Flächensensor beinhaltende Gerät ausgewählt ist aus der Gruppe umfassend Smartphones, Handys, Displays, Tablet-PCs, Tablet-Notebooks, Touchpad-Geräte, Grafiktabletts, Fernseher, PDAs, MP3-Player, Trackpads und/oder und kapazitive Eingabegeräte ohne darauf begrenzt zu sein. Ein kapazitiver Flächensensor kann beispielsweise auch Bestandteil von Eingabegeräten als Touchscreen, Touchpad oder Grafiktablett sein. Touchscreens sind auch als Tastschirm oder Sensorbildschirm bekannt. Derartige Eingabegeräte werden unter anderem in Smartphones, PDAs, Touchdisplays oder Notebooks eingesetzt. Ein Flächensensor muss sich dabei nicht zwingend vor einem Display befinden. Beispielsweise kann dieser auch als Tastatur ausgebildet und eingesetzt werden. Neben einer Klickfunktion ist auch eine Drag-and-Drop-Operation ausführbar. Weiterhin können mehrere gleichzeitige Berührungen in Form eines sogenannten "Multi-Touch" dazu verwendet werden, um zum Beispiel angezeigte Elemente insbesondere zu drehen oder zu skalieren. Der Flächensensor ist dabei bevorzugt als sogenannte Projected-Capacitive-Touch-Technik (PCT) ausgeführt. Varianten der PCT-Technik sind beispielsweise "Mutual Capacitance" und "Self Capacitance" welche ausgeführt sein können als Mutual-Capacitance-Screen und Self-Capacitance-Screen.

Die erfindungsgemäßen Informationsträger zeichnen sich vorteilhafterweise dadurch aus, dass damit eine Verbindung zu einem Gerät mit Flächensensor realisierbar ist. Der Flächensensor wirkt dabei bevorzugt analog einem kapazitivem Lesegerät, allerdings ohne hardwareseitig auf fest vorgegebene Leiterbahnen oder Lese-Elektroden angewiesen zu sein, wie sie derzeit limitierend aus dem Stand der Technik bekannt sind (US 3,719,804 - Permanenter Informationsspeicher). Durch die erfindungsgemäßen Informationsträger eröffnet sich eine Erweiterung des Funktionsumfangs von kapazitiven Flächensensoren beinhaltenden Geräten. Dadurch werden beispielsweise Informationen leichter zugänglich und/oder die Benutzung der Geräte vereinfacht (vor allem für körperlich eingeschränkte, behinderte oder ältere Menschen) und/oder neuartige Anwendungen ermöglicht, ohne darauf begrenzt zu sein.

Auf dem Informationsträger sind bevorzugt Informationen in Form der Touch-Struktur, die als Teilbereich ausgebildet sein kann, gespeichert. Die Informationen sind bei in Kontakt bringen oder Annäherung des Informationsträgers zum Flächensensor über diesen lesbar, wobei die Kapazität insbesondere partiell geändert wird.

Die die Information bildende Touch-Struktur, d. h. die Teilbereiche eines Bereichs bestehen aus einem elektrisch leitfähigen Material. Der Fachmann erkennt gemäß der Offenbarung der vorliegenden Erfindung, dass die Touch-Struktur aus Eckpunkten und/oder durch Kurven definierten Füllflächen besteht, beispielsweise Rechtecken, Kreisen oder ähnlichen Figuren. Die Ortsbeziehungen der Teilbereiche zueinander (Orientierung, Anzahl, Ausrichtung, Abstand und/oder Position) und/oder die Form der Teilbereiche stellen bevorzugt die Information dar. Bei der Positionierung des Informationsträgers an dem Flächensensor wird die Touch-Struktur beispielsweise als Finger-Eingabe interpretiert, so dass aus den Teilbereichen der Touch-Struktur die codierte Information bestimmbar ist, beispielsweise in Form einer binär codierten Zahl ohne darauf beschränkt zu sein. Es ist jedoch genauso ein Informationsträger direkt als solcher interpretierbar bzw. der Kontext der Anwendung des Informationsträgers bestimmt insbesondere seine spezifische Information. Das Positionieren kann dabei auch durch eine Relativbewegung des Informationsträgers zum Flächensensor erfolgen. Es ist bevorzugt, dass der Flächensensor in einer Bewegung relativ zum Informationsträger fortschreitend vollständig oder teilweise Informationen von dem Informationsträger erhält. Dabei können auch in Abhängigkeit der Positionen des Informationsträgers gegenüber dem Flächensensor verschiedene Ereignisse erzeugt werden. Ausschlaggebend dazu ist beispielsweise die Bewegungsrichtung oder Verweildauer des Informationsträgers gegenüber dem Flächensensor.

Der Informationsträgers kann vorteilhafterweise als einfacher, signierter oder verschlüsselter Informationsträgers ausgestaltet sein. Damit eignet sich der Informationsträger vorteilhafterweise als Schlüssel zur berechtigten Nutzung bestimmter Datenmengen oder Hardware, wobei die Kommunikation über ein bekanntes Datennetz wie zum Beispiel das Internet erfolgen kann. Das kann auch über ein Gerät erfolgen, welches über den Flächensensor verfügt.

Eine Aktion ist nachfolgend zusammenfassend Dasjenige, was bevorzugt durch ein Ereignis ausgelöst wird.

Im Zusammenhang mit einem Flächensensor beinhaltenden Gerät ist der Informationsträger

- ein einfacher Informationsträger, um Aktionen in dem Programmablauf auf dem Gerät selbst auszulösen,

- ein signierter Informationsträger, um Aktionen in dem Programmablauf des Gerätes und/oder einem externen Datenverarbeitungssystem, welches über ein Datennetz verbunden sein kann, auszulösen.

- ein verschlüsselter Informationsträger, welcher von dem Programmablauf des Gerätes und/oder eines externen Datenverarbeitungssystems entschlüsselt wird und Aktionen im Programmablauf des Gerätes oder des externen Datenverarbeitungssystems auslöst.

Auf dem Substrat befinden sich gemäß einer weiteren bevorzugten Ausführungsform mindestens zwei Touch-Strukturen mit jeweils mindestens einer assoziierten Koppelfläche. Mit dieser Anordnung können mindestens zwei Ereignisse ausgelöst werden, indem der Nutzer beispielsweise die jeweils assoziierte Koppelfläche berührt. Dadurch können beispielsweise ja/nein-Entscheidungen vom Nutzer über den Informationsträger ausgelöst werden.

Vorteilhafterweise können mehrere Informationsträger in Kombination, insbesondere nebeneinander und/oder übereinander und/oder zeitlich nacheinander, gelesen werden. Hierdurch ist es überraschenderweise möglich, komplexe Informationen auf einem Informationsträger, wobei der Informationsträger beispielsweise auf Karton und/oder Papier aufgedruckt ist, zu speichern. Der Informationsträger verbindet überraschenderweise Printmedien mit digitalen Medien, was derart zuvor nicht möglich war.

Es ist weiterhin bevorzugt, dass der Informationsträger einem Datensatz in einem Datenverarbeitungssystem zugeordnet ist und der Datensatz konstant bleibt. In einer bevorzugten Ausführungsform wird der Informationsträger einem Datensatz in einem Datenverarbeitungssystem zugeordnet und der Datensatz verändert. Dies kann beispielsweise durch Verwendung des Informationsträgers und/oder durch Zeit passieren, ohne darauf begrenzt zu sein.

Vorteilhafterweise kann der Informationsträger derart verwendet werden, dass der Informationsträger in Verbindung mit einem Flächensensor über die Touch-Struktur einer Aktion eines Datenverarbeitungssystems zugeordnet werden kann oder diese auslöst. Diese Aktion trifft insbesondere auf nicht-vernetzte Datenverarbeitungssysteme und besonders bevorzugt auf vernetzte Datenverarbeitungssysteme zu.

Die Erfindung betrifft auch die Verwendung eines kapazitiven Informationsträgers zur Erfassung von Informationen. Hierbei wird mindestens ein kapazitiver Flächensensor und mindestens ein kapazitiver Informationsträger bereitgestellt, wobei der Informationsträger ein elektrisch nicht leitendes Substrat aufweist, welches mindestens eine elektrisch leitfähige Touch-Struktur umfasst. Der mindestens eine Informationsträger wird mit dem mindestens einen Flächensensor in Kontakt gebracht, wobei der Kontakt statisch und/oder dynamisch sein kann. Dabei beschreibt ein statischer Kontakt, dass insbesondere im Moment der Auswertung des Informationsträgers keine oder eine unwesentliche Relativbewegung zum Flächensensor stattfindet. Im Gegensatz dazu beschreibt ein dynamischer Kontakt, dass insbesondere eine Relativbewegung während der Auswertung des Informationsträgers stattfinden kann. Der Kontakt kann erfindungsgemäß auch eine Annäherung umfassen. Durch den Kontakt wird eine kapazitive Wechselwirkung ausgelöst, wobei durch die kapazitive Wechselwirkung Informationen von dem Informationsträger auf den Flächensensor übertragen werden.

Der Bereich der elektrisch leitfähigen Schicht - der Touch-Struktur - besteht bevorzugt aus Teilbereichen. Insbesondere die Form, Orientierung, Anzahl, Ausrichtung, Abstand und/oder Position der Teilbereiche bilden die Informationen des Informationsträgers, so dass bei in Kontakt bringen des Informationsträgers mit dem Flächensensor ein Ereignis ausgelöst wird. Dabei kann der Programmablauf eines Gerätes mit dem Flächensensor gesteuert werden. Die Teilbereiche, d. h. die Touch-Struktur bestehen bevorzugt aus Eckpunkten und/oder durch Kurven definierten Füllflächen, beispielsweise Rechtecke, Kreise oder ähnliche Figuren.

Die Teilbereiche können beispielsweise 8 mm große Kreise sein. Damit sind sie virtuell auf einem Flächensensor von 50 mm Breite und 75 mm Höhe bei 163 ppi (pixel per inch) Auflösung rund 50x50 Pixel groß. Die Teilbereiche einer Größe von 8 mm können 54-mal auf dem Flächensensor in einer Anordnung von 6 x 9 aufgeteilt werden. Damit ergibt sich folgendes:

Die Position der Teilbereiche ist bis auf die Hälfte ihres Durchmessers bestimmbar, die Anzahl der möglichen Positionen verdoppelt sich dadurch pro Achse, jeweils eine Position am Rand entfällt jedoch. Damit sind (6*2 - 1) x (9*2 - 1), also 11x17 Positionen unterscheidbar.

Eine belegte Position sperrt im Extremfall neun mögliche benachbarte Positionen. Bei fünf benutzten Positionen fallen von den 17 x 11 = 187 möglichen Positionen also 5 x 9 = 45 Positionen weg. Damit bleiben 142 freie Positionen. Die freien Positionen als Teilbereiche unterliegen dem Binomialkoeffizienten.

Also ergibt die Formel $\binom{142}{5}$ die möglichen Anordnungen der Teilbereiche. In diesem Fall sind das 448072338 verschiedene Anordnungen von Teilbereichen möglich. Diese Zahl kann als Binärzahl mit 29 Stellen dargestellt werden. Daraus ergeben sich mindestens $2^{28}$ mögliche Anordnungen und es können 28 Bit an Daten dargestellt werden.

Für die Anzahl an Teilbereichen von 5 bis 18 ergibt sich folgende Tabelle:

| | | | | | | | |
|---|---|---|---|---|---|---|---|
| 5 | * | 9 | = | 45 | 142 | über 5 | $< 2^{29}$ |
| 6 | * | 9 | = | 54 | 133 | über 6 | $< 2^{33}$ |
| 7 | * | 9 | = | 63 | 124 | über 7 | $< 2^{37}$ |
| 8 | * | 9 | = | 72 | 115 | über 8 | $< 2^{40}$ |
| 9 | * | 9 | = | 81 | 106 | über 9 | $< 2^{42}$ |

(fortgesetzt)

| | | | | | | | |
|---|---|---|---|---|---|---|---|
| 10 | * | 9 | = | 90 | 97 | über 10 | $< 2^{44}$ |
| 11 | * | 9 | = | 99 | 88 | über 11 | $< 2^{45}$ |
| 12 | * | 9 | = | 108 | 79 | über 12 | $< 2^{46}$ |
| 13 | * | 9 | = | 117 | 70 | über 13 | $< 2^{46}$ |
| 14 | * | 9 | = | 126 | 61 | über 14 | $< 2^{45}$ |
| 15 | * | 9 | = | 135 | 52 | über 15 | $< 2^{43}$ |
| 16 | * | 9 | = | 144 | 43 | über 16 | $< 2^{38}$ |
| 17 | * | 9 | = | 153 | 34 | über 17 | $< 2^{32}$ |
| 18 | * | 9 | = | 162 | 25 | über 18 | $< 2^{19}$ |

Demnach ergibt sich mit zwölf Teilbereichen ein Maximum von 45 Bit Daten, welche nach diesem Beispiel darstellbar sind. Daraus ergibt sich:

- bei maximal fünf Teilbereichen sind bis maximal 28 Bit auf einem Informationsträger 1 unterzubringen und

- bei zwölf Teilbereichen sind bis maximal 45 Bit auf einem Informationsträger 1 unterzubringen.

Die Datenmenge ist durch Verkleinerung der Teilbereiche wesentlich vergrößerbar.

Die Erfindung betrifft auch eine Methode zur Erkennung eines kapazitiven Informationsträgers, welche vorzugsweise auf einem Computer-basierenden System mit einem berührungsempfindlichen Bildschirm (= Touch Screen) installiert ist. Die Methode umfasst die Bereitstellung einer kapazitiven Baseline, die Generierung eines Stromsignals, wenn der kapazitive Informationsträger mit dem Touch-Screen in Kontakt gebracht oder an diesen angenähert wird. Durch den Vergleich der kapazitiven Baseline mit dem generierten Signal, wird ein Ereignis ausgelöst.

Sobald ein ein Touch-Screen aufweisendes Computer-basiertes System den kapazitiven Informationsträger erkennt (durch Kontakt oder Annäherung), wird ein Ereignis ausgelöst. Es kann jedoch auch bevorzugt sein, wenn der Touch-Screen den Informationsträger lediglich erkennt und die Information an einen Computer weitergibt, der entsprechend ein Ereignis auslöst. Der Touch-Screen kann Bestandteil eines Bildschirms, umfassend monochromer Bildschirm, Farbbildschirm (CGA, EGA, VGA, super VGA), LCD-, CRT-, LED, OLED oder Plasmabildschirm sein. Es kann jedoch auch vorteilhaft sein, wenn der Touch-Screen nicht in den Bildschirm integriert ist, sondern als separate Komponente ausgeführt ist. Der Touch-Screen kann beispielsweise als Touch-Pad oder Track-Pad ausgestaltet sein. Der Touch-Screen leitet vorzugsweise die durch den Informationsträger erhaltenen Informationen an ein Daten verarbeitendes Gerät weiter, wodurch bevorzugt ein Ereignis ausgelöst wird.

Das Ereignis wiederum löst bevorzugt eine Aktion aus. Die Aktion kann beispielsweise das Registrieren an einem Computer oder einem Computernetzwerk sein, oder den Zugang zu einem eingeschränkten Bereich, das Laden eines Computerprofils mit einem dazugehörigen persönlichen Einstellungen eines Computers, Zugang zu Web-Inhalten, Start eines Computerprogrammes, Öffnen und/oder Schließen eines Dokumentes, Betrachten eines Menüs, Ausführen von weiteren Aktionen, Verschlüsseln und/oder Entschlüsseln eines Dokumentes oder Bedienen eines Eingabe- und/oder Ausgabegerätes. Es kann auch bevorzugt sein, dass mehrere Informationsträger kombiniert werden müssen, um beispielsweise Zugang zu zugangsbeschränkten Bereichen zu erhalten. Hierbei können die notwendigen Informationsträger an unterschiedliche Personen ausgeteilt werden, was einen hohen Sicherheitsstandard erfüllt. Mehrere Informationsträger können auch zu einer zusammengehörenden Sequenz kombiniert werden, so dass erst bei Erreichen der Gesamtsequenz ein Ereignis ausgelöst wird. Der Informationsträger kann beispielsweise dazu verwendet werden, ein Ereignis auszulösen, welches persönliche Daten, Bankdaten oder Kreditkartendaten ausgibt. Dies kann insbesondere im Bankensektor oder im Einzelhandel vorteilhaft sein.

Der Informationsträger kann auch zu Werbezwecken verwendet werden, indem er beispielsweise als Los genutzt wird und Zugang zu einer Homepage herstellt, auf der über einen potentiellen Gewinn entschieden wird. Der Informationsträger kann auch als Promotionartikel mit anderen Artikeln verschenkt oder verkauft werden. Der Empfänger kann mittels des Informationsträgers Zugang zu Werbeinformationen oder Produktinformationen erhalten. Beispielsweise kann er insbesondere mittels des Informationsträgers Webseiten öffnen, die ein Benutzerhandbuch für ein erworbenes Produkt beinhalten.

Das Betriebssystem des Computers oder des Gerätes, das einen Touch-Screen aufweist, verfügt vorteilhafterweise über ein Programm, insbesondere ein Erkennungsprogramm, welches die Methode zur Erkennung eines kapazitiven Informationsträgers umfasst. Betriebssysteme sind hinreichend bekannt und umfassen OS/2, DOS, UNIX, Linux, Windows, Windows Mobile, Android-basierende Systeme, iOS, Mac OS, Darwin usw. Das Erkennungsprogramm kann in dem Betriebssystem implementiert sein oder als separate Software ausgeführt werden. Vorzugsweise ist das Erkennungsprogramm im ROM oder RAM gespeichert.

Das Erkennungsprogramm kann ebenfalls auf einem externen Speichermedium, umfassend CD-ROM, PC-CARD, Diskette, magnetisches Speichermedium oder Netzwerkkomponente, gespeichert werden. Es kann auch vorteilhaft sein, wenn das Erkennungsprogramm im Touch-Screen selbst gespeichert ist (z. B. in der Firmware). Das Erkennungsprogramm ist vorzugsweise für einen Benutzer zugänglich, was beispielsweise auf dem Touch-Screen dargestellt werden kann. Der Benutzer kann Einstellungen ändern und/oder eine Region auf dem Bildschirm festlegen, auf der der Informationsträger bevorzugt erkannt wird. Prinzipiell besteht das Erkennungsprogramm aus Befehlen, die einen Kontakt mit dem Informationsträger erkennen und das Betriebssystem hierüber informieren und/oder ein Ereignis auslösen.

Der Computer ist bevorzugt ein PC (Personalcomputer) umfassend ein Desktop-Rechner, Laptop oder Smartphone. Der Computer kann aber auch Bestandteil eines öffentlichen Computersystems sein, wie beispielsweise öffentliches Computerterminal, Geldautomaten (ATM), POS (point of sale Maschinen), industrielle Computersysteme, Spielkonsolen, Spielautomaten, Ticketautomaten, Reservierungsautomaten, Servicestationen und viele mehr.

Die auf dem Informationsträger aufgebrachte Touch-Struktur kann vorteilhafterweise einfache und/oder komplexe Strukturen umfassen. Es können beispielsweise Kreise, Quadrate, Rechtecke, Punkte, Dreiecke, Logos, Symbole, Text oder ähnliche aufgebracht sein. Weiterhin ist es bevorzugt, die Struktur als binärer Code oder Blindenschrift auszuführen. Die Struktur kann auch einen Hinweis auf die auszuführende Aktion sein. Die Struktur kann beispielsweise die Form eines Schlüssels haben, der darauf hinweist, dass mit dem Informationsträger, bzw. der Struktur ein Zugang geöffnet wird. Die Struktur kann auch beispielsweise auf einer bestehenden Karte, z. B. einer Kreditkarte aufgebracht werden. Der Touch-Screen kann Bestandteil jeglichen Computersystems sein, welches Daten senden, empfangen und/oder speichern kann. Das Computersystem kann ein PC, Laptop, Handheld-Computer, IBM-, Windows- oder Apple-kompatibler Computer sein.

Im Folgenden soll die Verwendung des Informationsträgers anhand von Beispielen erläutert werden, ohne jedoch auf die Beispiele begrenzt zu sein:

Verwendung des Informationsträgers zum Erwerb von Produkten oder Waren

Der Informationsträger kann zum Erwerb von Waren oder Produkten verwendet werden. Beispielsweise kann ein Geschäft oder ein Kiosk ein ein Touch-Screen aufweisendes Gerät beherbergen, welches für einen Kunden zugänglich ist. Der Kunde verfügt über einen Informationsträger, mit dem er sich bei dem Geschäft oder Kiosk über das Gerät identifizieren kann. Durch die Benutzung des Informationsträgers kann sich der Kunde an dem Gerät identifizieren und beispielsweise seine bereits erworbenen Waren und persönliche Daten einsehen. Die Identifikation erfolgt über den Informationsträger, der mit dem Flächensensor des Gerätes - dem Touch-Screen - in Kontakt gebracht werden oder sich diesem annähern muss. Der Touch-Screen wird im Sinne der Erfindung insbesondere auch als Flächensensor bezeichnet.

Vorteilhafterweise ist das einen Touch-Screen aufweisende Gerät mit dem Internet oder weiteren Computern oder Geräten zu einem Netzwerk verbunden, wodurch Informationen austauschbar sind. Der Kunde kann beispielsweise über eine Gutschrift verfügen, die mittels des Informationsträgers abrufbar ist, wobei über das Netzwerk der aktuelle Betrag der Gutschrift ermittelt werden kann. Nach dem Laden der persönlichen Daten und bereits erworbenen Waren, kann der Kunde entscheiden, ob er die gleichen Waren erneut erwerben möchte. Dies ist insbesondere dann vorteilhaft, wenn es beispielsweise um den Erwerb einer Zeitung oder den Kauf von Grundnahrungsmittel geht, die regelmäßig erworben werden. Der Kunde kann beispielsweise auch über einen Informationsträger Zugang zu einer Leseprobe eines Buches oder zu einem Probeabonnement einer Zeitung oder eines Magazins erhalten. Hierdurch kann einem Käufer eines Magazins ein Informationsträger in Form eines Werbeflyers zugestellt werden. Der Käufer kann mittels seines Smartphones den Informationsträger auslesen und erhält Zugang zu Informationen über ein bestimmtes Produkt. Es steht dem Käufer auch frei, das Produkt bereits zu bestellen oder es sich auf der Webpage des Produktanbieters anzusehen. Auch die Anbieter und die Standorte der Anbieter werden dem Käufer mitgeteilt.

Vorteilhafterweise kann der Informationsträger auch in einem Magazin oder einer Zeitung abgedruckt sein und beispielsweise eine Werbung eines Reiseveranstalters umfassen. Ein Interessent kann ein Gerät, das über einen Flächensensor verfügt, mit der Werbung - dem Informationsträger - in Kontakt bringen und erhält Informationen über die angebotene Reise. Falls der Interessent die Reise buchen möchte, kann er dies über das Gerät, z. B. einem Smartphone direkt tun. Hierfür kontaktiert ein Programm auf dem Smartphone über das Internet ein weiteres Programm des Reiseveranstalters, dem die persönlichen Daten und Kreditkartendaten des Interessenten mitgeteilt werden. Falls der Interessent mit dem vorgeschlagenen Preis einverstanden ist, kann er die Reise buchen. Er erhält dann postalisch oder digital die Reisebestätigung. Durch eine ähnliche Vorgehensweise können auch Flüge gebucht werden, die in einer Zeitung oder einem Magazin inseriert sind.

Es kann auch vorteilhaft sein, dass ein Informationsträger einem Restaurantbesucher angeboten wird und der Besucher mittels des Informationsträgers und einem ein Touch-Screen aufweisendem Gerät (z. B. einem Smartphone) auf eine Webpage des Restaurants zugreifen kann, auf der die Rezepte der in dem Restaurant angebotenen Speisen erhältlich sind. Vorteilhafterweise ist es auch möglich, die für die Rezepte benötigten Waren direkt online zu bestellten. Außerdem können dem Besucher Informationen über Bestandteile der Speisen angezeigt werden, was insbesondere für Allergiker wichtig ist.

Auch können dem Besucher mittels des erhaltenen Informationsträgers spezielle Veranstaltungen mitgeteilt werden, die in dem Restaurant stattfinden. Die Veranstaltungen oder sonstigen erhaltenen Informationen können vorteilhafterweise direkt in dem Gerät, beispielsweise dem Smartphone gespeichert werden und in z. B. einem Kalender vorgemerkt werden. Auch der automatische Eintrag des Restaurants in eine Kontaktdatenbank des Smartphones kann von dem Besucher veranlasst werden, da dem Besucher die Kontaktdaten durch den Informationsträger zur Verfügung stehen.

Vorteilhafterweise ist zum Erwerb von Waren oder Produkten kein Personal nötig. Die Waren oder Produkte können von dem Kunden bestellt und ihm erst später zugestellt werden. Es ist auch möglich, dass durch den Informationsträger eine Aktion ausgelöst wird, durch die ihm beispielsweise ein Produkt direkt zukommt. Beispielsweise kann durch den Informationsträger ein einen Touch-Screen aufweisenden Süßigkeits- oder Zeitungsautomat bedient werden. Das durch den Kunden erworbene Produkt wird auf dem Touch-Screen angezeigt und der Kunde kann den Kauf bestätigen oder ablehnen. Hierfür können dem Kunden auf dem Touch-Screen beispielsweise zwei Flächen zum Betätigen angeboten werden. Erst nachdem der Kunde den Kauf bestätigt hat, wird der Kauf ausgelöst. Nach dem Kauf erhält der Kunde auf dem Touch-Screen eine Zusammenfassung seines Kaufes, die auf dem Speichermedium des Gerätes speicherbar ist.

Es kann auch bevorzugt sein, dass der Informationsträger auf einem erworbenen Produkt oder der Verpackung des Produktes angebracht ist. Durch den Informationsträger erhält der Kunde, der das Produkt erworben hat, Zugang zu produktspezifischem Informationsmaterial oder Zubehör. Der Kunde muss lediglich den Informationsträger mit dem Touch-Screen in Kontakt bringen oder diesem annähern, wodurch eine Aktion ausgelöst wird, durch die dem Kunden beispielsweise eine bestimmte Webpage im Internet angezeigt, ein bestimmtes Programm gestartet oder dem Kunden ein Video angezeigt wird.

Der Informationsträger kann beispielsweise auf Verpackungen von Lebensmitteln gedruckt werden. Ein Käufer benutzt beispielsweise sein Smartphone, um die Information des Informationsträgers auszulesen und erhält so Zugang zu spezifischen Informationen über das erworbene Lebensmittel, umfassend Rezepte, Bestandteile und/oder Kochanweisungen (Video und/oder Audio).

Es kann auch bevorzugt sein, mittels dem Informationsträger Waren über ein Fernsehgerät zu erwerben. Das Fernsehgerät verfügt bevorzugt über einen Flächensensor, bevorzugt einen kapazitiven Touch-Screen. Der Informationsträger kann mit dem Touch-Screen des Fernsehgeräts in Kontakt gebracht oder diesem angenähert werden. Beispielsweise kann bei Verkaufssendern ein Produkt erworben werden, indem sich der Kunde mittels des Informationsträgers identifiziert und hierdurch das Produkt erworben wird.

Der Informationsträger kann vorzugsweise dazu verwendet werden, Programme auszulösen. Eine Person kann beispielsweise nach einem Konzertbesuch einen Informationsträger erwerben. Der Informationsträger wird von der Person zuhause in Kontakt mit einem einen Touch-Screen aufweisenden Gerät gebracht oder an dieses angenähert, wodurch ein Ereignis und eine Aktion ausgelöst wird. Vorteilhafterweise verfügt das Gerät über einen Internetzugang und ermöglich der Person Zugang einer Webpage, auf der Produkte des zuvor besuchten Konzertes angeboten werden. Die Person kann sich ebenfalls auf der Webpage ein Video des besuchten Konzertes ansehen, wobei sich die Person zuvor mit dem Informationsträger identifizieren muss. Nur durch den Informationsträger erhält sie Zugang zu bestimmten zugangsbeschränkten Bereichen auf der Webpage.

Verwendung des Informationsträgers als Beilage eines Druckerzeugnisses

Der Informationsträger kann auch als Bestandteil eines Lehrbuches gedruckt werden oder diesem beiliegen. In dem Lehrbuch sind Aufgaben enthalten, die z. B. ein Student lösen kann. Nach dem Lösen der Aufgaben kann der Student ein einen Touch-Screen aufweisendes Gerät, z. B. ein Smartphone mit dem Informationsträger in dem Lehrbuch in Kontakt bringen oder an dieses annähern und erhält so Zugang zu den Lösungen, die sich beispielsweise auf einer zugangsbeschränkten Webpage befinden. Auch können so Videos oder Audiodateien zugänglich sein, die den Student beim Lernen unterstützen können.

Es kann auch bevorzugt sein, dass der Informationsträger einem Buch beiliegt oder auf diesem gedruckt ist. Ein Käufer des Buches erhält über den Informationsträger und über ein einen Touch-Screen aufweisendes Gerät Zugang zu einer Webpage, auf der weitere Bücher des Autors angeboten werden und ggf. Trailer einer geplanten Verfilmung des Buches zu sehen sind. Vor Kauf des Buches kann ein Interessent den Informationsträger auf dem Buch mit seinem Smartphone in Kontakt bringen, wodurch ihm eine Leseprobe auf dem Smartphone angezeigt wird. So ergibt sich für den Interessenten die Möglichkeit, das Buch vor dem Kauf Probe zu lesen.

Der Informationsträger kann ebenfalls auf die Verpackung einer DVD oder Blu-Ray gedruckt sein, oder dieser beiliegen. Der Informationsträger ermöglicht dem Käufer Zugang zu einer Webpage, die weitere Informationen über den erworbenen Film (z. B. Infos über Schauspieler oder Zusatzmaterial) umfasst. Vorteilhafterweise kann der Informationsträger auf die Verpackung einer DVD, einer Blueray oder eines Videospiels gedruckt sein. Ein potentieller Käufer kann mittels eines Smartphones den Informationsträger einlesen und ggf. eine Probe des zu erwerbenden Produktes unverbindlich testen.

Der Informationsträger kann ebenfalls bei dem Kauf eines Magazins oder einer Zeitung als Beilage mit erworben werden und den Zugang zu Programmen oder Webinhalten mittels einem einen Touch-Screen aufweisendem Gerät herstellen.

Verwendung des Informationsträgers als Gutschein

Der Informationsträger kann ebenfalls als Gutschein oder Rabattkarte verwendet werden. Der Informationsträger kann von einem Unternehmen als Werbung an potentielle Kunden versendet oder verteilt werden. Der Empfänger kann den Informationsträger an einem speziellen Terminal oder an ähnlichen Geräten mit einem Touch-Screen, die sich vorzugsweise in dem Unternehmen befinden, einlösen. Der Kunde kann sich beispielsweise für einen gewissen Geldbetrag ein Produkt des Unternehmens auswählen und mit dem Informationsträger bezahlen, indem er den Informationsträger mit dem Touch-Screen in Kontakt bringt oder an diesen annähert und hierdurch ein Ereignis ausgelöst wird. Der Informationsträger löst beispielsweise eine Aktion ähnlich zu einer Gutscheinkarte aus, wobei der Kunde den Gutschein zum Bezahlen des Produktes verwenden kann.

Der Informationsträger kann auch vorteilhafterweise als Gutschein im Internet verwendet werden. Ein Kunde kann beispielsweise Produkte im Internet erwerben und die Bezahlaktion durch in Kontakt bringen des Informationsträgers mit einem einen Touch-Screen aufweisenden Gerät auslösen. Der Informationsträger kann ebenfalls als Gutschein für einen Musikdownload oder ähnliches verwendet werden.

Es kann auch vorteilhaft sein, wenn mehrere Informationsträger von einer Person gesammelt werden und erst durch die Kombination einer zuvor definierten Anzahl an Informationsträgern ein Gutschein freigeschaltet wird. Beispielsweise können mehrere Informationsträger derart mit einem Touch-Screen kombiniert werden, dass erst eine bestimmte Anzahl an Informationsträgern ein Ereignis bzw. eine Aktion auslöst. Die einzelnen Informationsträger werden auf dem Touch-Screen als Bestandteil einer geometrischen Figur dargestellt, so dass für die Person erkennbar ist, wie viele Informationsträger er noch benötigt, um die Figur zu vervollständigen. Eine vervollständigte Figur kann vorzugsweise auf dem den TouchScreen aufweisenden Gerät gespeichert werden und ggf. mit anderen Personen, die ebenfalls Informationsträger sammeln, ausgetauscht werden. Die Geräte können untereinander über ein Netzwerk oder andere Kommunikationskanäle, umfassend Bluetooth, Infrarot usw., kommunizieren.

Verwendung des Informationsträgers als Ticket

Es kann auch bevorzugt sein, dass der Informationsträger als Ticket verwendet wird. Der Informationsträger kann beispielsweise als Kinoticket genutzt werden. Einer Person kann der Informationsträger im Zuge einer Werbeaktion zugestellt werden oder die Person erhält den Informationsträger als Zeitungsbeilage. Selbstverständlich kann die Person den Informationsträger auch direkt bei einer Verkaufsstelle erwerben. Der Informationsträger ermöglicht der Person z. B. Zugang zu einem Kino, insbesondere zu einem bestimmten Kinofilm. Am Eingang des Kinos muss die Person lediglich den Informationsträger mit einem Touch-Screen in Kontakt bringen, wobei der Touch-Screen Bestandteil eines Gerätes in dem Kino ist. Durch den Kontakt oder eine Annäherung wird ein Ereignis bzw. eine Aktion ausgelöst und die Person bekommt vorzugsweise ein Kinoticket ausgestellt.

Vorzugsweise kann der Informationsträger bereits auf ein Produkt oder ein Ticket gedruckt sein. Der Informationsträger kann auch auf eine Verpackung gedruckt sein. Als Druckverfahren wird bevorzugt ein Transferverfahren, bevorzugt ein Transferfolienverfahren verwendet. So kann beispielsweise der Informationsträger auf eine Verpackung einer CD gedruckt sein. Ein Käufer der CD erhält durch den Informationsträger Zugang zu weiteren Musikstücken oder zu Merchandising Produkten des Interpreten.

Verwendung des Informationsträgers als Visitenkarte

Der Informationsträger kann ebenfalls als Visitenkarte verwendet werden. Ein Inhaber eines Informationsträgers kann auf dem Informationsträger persönliche Daten speichern und diesen als Visitenkarte an andere Personen weitergeben. Die Personen führen den Informationsträger lediglich an einen Touch-Screen, wodurch eine Aktion ausgelöst wird. Die Aktion kann beispielsweise darin bestehen, dass die private Homepage des Inhabers des Informationsträgers geöffnet wird. Die persönlichen Daten werden vorzugsweise direkt auf dem einen Touch-Screen aufweisenden Gerät gespeichert und beispielsweise in die Kontaktdatenbank übertragen.

### Verwendung des Informationsträgers als Schlüssel

Es kann auch bevorzugt sein, dass der Informationsträger als Schlüssel verwendet wird. Das heißt, nur mithilfe des Informationsträgers erhält der Inhaber Zugang zu zugangsbeschränkten Bereichen. Der Inhaber identifiziert sich beispielsweise an einer Tür mithilfe des Informationsträgers, wodurch auf einem Touch-Screen, welches an der Tür angebracht ist, eine Aktion ausgelöst wird, durch die ggf. ein Öffnen der Tür erreicht wird.

Vorteilhafterweise können auch für den Zugang zu zugangsbeschränkten Bereichen mehrere Informationsträger verwendet werden. Der Zugang zu beispielsweise Hochsicherheitsbereichen kann nur durch die Verwendung von zwei unterschiedlichen Informationsträgern, die an zwei unterschiedliche Personen ausgegeben wurden, erlangt werden. Auch das Auslösen von wichtigen Programmen kann derart restringiert werden, indem die Programme nur durch die Verwendung von mindestens zwei unterschiedlichen Informationsträgern, die vorzugsweise an zwei unterschiedliche Personen verteilt wurden, gestartet werden können.

### Verwendung des Informationsträgers mit einem Smartphone

Der Informationsträger kann vorteilhafterweise auch mit Smartphones interagieren. Hierfür wird der Informationsträger mit dem kapazitiven Touch-Screen des Smartphones in Kontakt gebracht oder an dieses angenähert, wodurch ein Ereignis auf dem Smartphone ausgelöst wird, das wiederum ein Programm starten kann. Das Smartphone zeigt bevorzugt die Erkennung des Informationsträgers an und bietet dem Benutzer vorteilhafterweise verschiedene Schritte zur Auswahl. So kann der Benutzer das Programm sofort oder erst später auslösen. Dies kann insbesondere vorteilhaft sein, wenn die Herstellung einer Internetverbindung nicht möglich ist und die Verbindung zu einem späteren Zeitpunkt hergestellt werden soll. Der Benutzer erhält dann eine Nachricht auf dem Touch-Screen, dass zur Zeit keine Internetverbindung besteht, wobei er auswählen kann, ob eine Verbindung sofort oder erst später hergestellt werden soll. Vorteilhafterweise werden dem Benutzer auch Informationen über den Informationsträger angezeigt, die ggf. in dem Speicher des Smartphones gespeichert werden. Der Informationsträger kann auch dem Smartphone Befehle mitteilen, die wiederum von einem Programm umgesetzt werden. So kann beispielsweise ein Programm einen Hyperlink ausführen und eine bestimmte Internet Webpage direkt oder über einen Web-Service kontaktieren.

Der Informationsträger kann in diesem Zusammenhang auch als Zertifikat oder Authentisierungsmittel verwendet werden, indem er dem Benutzer den Zugang zu bestimmten Webseiten oder Programmen erst ermöglicht. Beispielsweise kann der Informationsträger ein Passwort enthalten, das mittels des Touch-Screens auf das Gerät übertragen wird und mit dessen Bereitstellung erst der Zugang zu restringierten Inhalten möglich wird. Smartphones können dazu verwendet werden, Emails zu senden und zu empfangen. Falls eine Email decodiert ist, kann diese nach Erhalt nicht gelesen werden. Erst wenn beispielsweise ein Code eingegeben worden ist, wird die Email lesbar. Es ist auch möglich, den Informationsträger als Authentisierungsmittel zu verwenden. Einem potentiellen Empfänger von decodierten Emails wird ein Informationsträger zugestellt. Nach Erhalt einer decodierten Email wird der Empfänger aufgefordert, den Informationsträger an den Touch-Screen zu führen, wodurch die Information auf dem Informationsträger auslesbar sind. Die gelesene Information wird geprüft und sobald eine positive Validierung erfolgte, kann die Email von dem Empfänger gelesen werden.

### Verwendung des Informationsträgers als Shopping-Guide

Der Informationsträger kann auf Produkte oder Waren aufgedruckt sein. Ist ein Kunde an den Produkten interessiert, aber keine Beratung über die Produkte möglich, kann der Kunde den Informationsträger mit seinem Smartphone oder einem sonstigen Gerät, das einen kapazitiven Touch-Screen aufweist, in Kontakt bringen oder an dieses annähern. Der Informationsträger löst ein Ereignis bzw. eine Aktion aus, durch die beispielsweise die Webpage des Produktherstellers auf dem Smartphone angezeigt wird. Hier kann der Kunde weitere Informationen über das Produkt in Erfahrung bringen. Die Information kann in Textform, als Video- oder Audio-Datei vorliegen und beispielsweise die Verwendung des Produktes, spezifisches Zubehör oder sonstiges umfassen.

Es kann auch bevorzugt sein, dass der Informationsträger als Werbeflyer von einem Geschäft verteilt wird. Ein Interessent kann den erhaltenen Informationsträger mit einem Gerät, welches über einen Flächensensor verfügt, kombinieren. Der Informationsträger löst ein Ereignis bzw. eine Aktion aus, so dass dem Interessenten auf dem Smartphone angezeigt wird, wie er von seinem Standort zu dem Geschäft gelangt. Gleichzeitig kann er über den Informationsträger einen Rabattgutschein für das Geschäft erhalten.

### Verwendung des Informationsträgers als Bezahlmittel

Der Informationsträger kann beispielsweise auf die Verpackung von Produkten oder Waren gedruckt sein. Ist ein Kunde an dem Produkt interessiert, kann er sich wie oben dargestellt, Informationen über das Produkt mittels des Informationsträgers ansehen. Es ist jedoch auch möglich, das Produkt direkt zu erwerben. Der Informationsträger übermittelt beispielsweise einem Smartphone wichtige Daten des Produktes, wie z. B. Preis. Das Smartphone verfügt vorteilhafterweise über einen Internetzugang und über ein Programm, dass den Erwerb des Produktes über das Internet ermöglicht. Nachdem der Informationsträger mit dem Smartphone in Kontakt gebracht wurde und das Smartphone über alle zum Kauf notwendigen Informationen verfügt, kann der Kauf abgeschlossen werden. Das Programm sendet die Informationen über das Produkt und Kunden über das Internet an ein weiteres Programm, das die Abwicklung des Kaufes übernimmt. Diesem Programm werden die Daten des Kunden, wie Adresse und Bankdaten und/oder Kreditkartendaten mitgeteilt. Nachdem der Kauf bestätigt wurde, wird dem Kunden dies signalisiert und er kann das Produkt an sich nehmen. Eine Bestätigung über den erfolgreichen Kauf, die ebenfalls an das Smartphone gesendet wird, kann als Nachweis über den Kauf dienen und als Vorlage an beispielsweise dem Ausgang des Kaufhauses verwendet werden.

Verwendung des Informationsträgers in Kombination mit einem Mikrochip

Es kann auch vorteilhaft sein, wenn auf dem Informationsträger ein Mikrochip angeordnet ist. Der Mikrochip kann vorteilhafterweise aktiv oder passiv elektronische Informationen, wie beispielsweise Seriennummern oder Codes, an einen elektronischen Empfänger übermitteln. Ein Benutzer des Informationsträgers kann sich beispielsweise mittels des Informationsträgers an einem einen Touch-Screen aufweisenden Gerät identifizieren, wobei das Gerät weitere Informationen von dem Mikrochip erhält. Es kann jedoch auch vorteilhaft sein, wenn ein Barcode auf dem Informationsträger aufgebracht ist. Der Barcode kann in Form eines 2-dimensionalen Codes auf den Informationsträger aufgebracht sein und ebenfalls zur Codierung von beispielsweise einer Seriennummer dienen. Der Barcode kann z. B. ein Matrix-Code, ein QR-Code oder ein Aztec-Code sein. Der Mikrochip und/oder der Barcode können ebenfalls zur Identifizierung des Informationsträgers verwendet werden.

Verwendung des Informationsträgers als Stadtführer

Der Informationsträger kann an Sehenswürdigkeiten angebracht werden. Beispielsweise kann er an einem Denkmal oder einem Gebäude auf einer Tafel aufgebracht sein. Ein Tourist, der vorzugsweise über ein Smartphone oder ein sonstiges Gerät mit einem Flächensensor verfügt, kann bei einem Rundgang die Tafel betrachten und bei Bedarf sein Smartphone mit dem Informationsträger in Kontakt bringen. Hierdurch wird auf dem Smartphone eine Aktion ausgelöst, durch die dem Tourist eine Webpage angezeigt wird, auf der er zusätzliche Informationen über die Sehenswürdigkeit erfahren kann. Die Informationen können beispielsweise als Text oder als Video vorliegen. Bei Bedarf können über die Webpage auch Merchandising Produkte der Sehenswürdigkeit erworben werden, die direkt zur Heimatadresse des Touristen gesendet werden.
Es kann auch vorteilhaft sein, wenn in einem bestimmten Bezirk, der regelmäßig von Touristen besucht wird, in einer zentralen Lage ein Informationsträger auf einem Gegenstand angebracht ist. Nachdem der Tourist sein Smartphone mit dem Informationsträger in Kontakt gebracht hat, erhält er Informationen über den Bezirk. Die Informationen können beispielsweise über ein Programm oder über das Internet bereitgestellt werden und Video- und Audio-Daten umfassen. Der Tourist wird über Restaurants, Geschäfte, Sehenswürdigkeiten und ggf. deren Rabattaktionen informiert.

Verwendung des Informationsträgers als Sicherheitsmerkmal

Der Informationsträger kann vorteilhafterweise als Sicherheitsmerkmal auf Dokumente oder Ausweise aufgebracht werden. Hierfür kann der Informationsträger auf das Substrat - wie z. B. eine Banknote - aufgedruckt werden, wobei der Informationsträger sichtbar oder nichtsichtbar auf der Banknote vorliegen kann. Zur Verifizierung der Banknote kann diese mit einem Lesegerät oder einem Flächensensor in Kontakt gebracht werden, wodurch der Informationsträger vorzugsweise kapazitiv ausgelesen wird und hierdurch die Echtheit der Banknote verifiziert werden kann. Der Informationsträger kann nicht nur die Echtheit der Geldscheine verifizieren, sondern auch zur Zählung oder Wertbestimmung der Scheine verwendet werden. Beispielsweise können sehbehinderte Personen mit einem Lesegerät oder einem Flächensensor (z. B. einem Touchscreen) die Werte der Geldscheine bestimmen, indem der Informationsträger den entsprechenden Wert codiert und dieser durch das Lesegerät oder den Flächensensor ausgelesen wird. Auch ist es möglich, den Informationsträger in Kreditkarten oder Ausweise zu integrieren, um eine Echtheit zu verifizieren.
Die Erfindung wird nunmehr anhand von Figuren beispielhaft beschrieben, ohne jedoch auf diese beschränkt zu sein; es zeigt:

Fig. 1 bis Fig. 4          Draufsichten von bevorzugten Ausgestaltungen eines Informationsträgers

Fig. 5a und Fig. 5b        Informationsträger in einer Schnittdarstellung

Fig. 6 und Fig. 7        Informationsträger mit Leiterbahnen

Fig. 8 bis Fig. 11       Informationsträger mit Leiterbahnen und Koppelfläche(n)

Fig. 12a und Fig. 12b    Informationsträger mit einer Deckschicht in einer Schnittdarstellung

Fig. 13 und Fig. 14      Informationsträger an einem Gegenstand

Fig. 15 bis Fig. 20      Interaktion eines oder mehrerer Informationsträger mit einem Flächensensor

Fig. 21 bis Fig. 25      bevorzugte Anwendungen eines Informationsträgers

Fig. 26 bis Fig. 28      Verwendung eines Informationsträgers an einem einen Flächensensor aufweisenden Gerät

Fig. 29                  Bewegung eines Informationsträgers an einem Gerät

Fig. 30 bis Fig. 34      Bevorzugte Verwendungen eines Informationsträgers

Fig. 35 bis Fig. 38      Verwendung des Informationsträgers als Sicherheitsmerkmal auf einem Geldschein

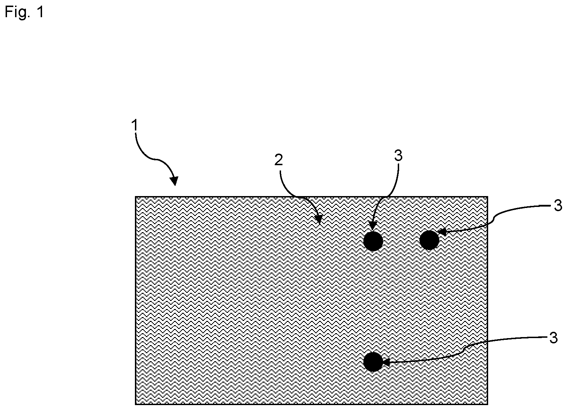

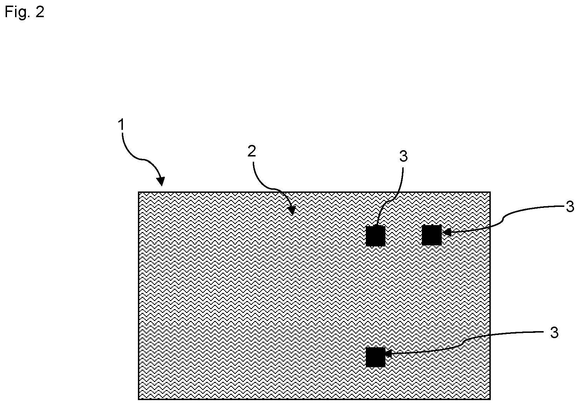

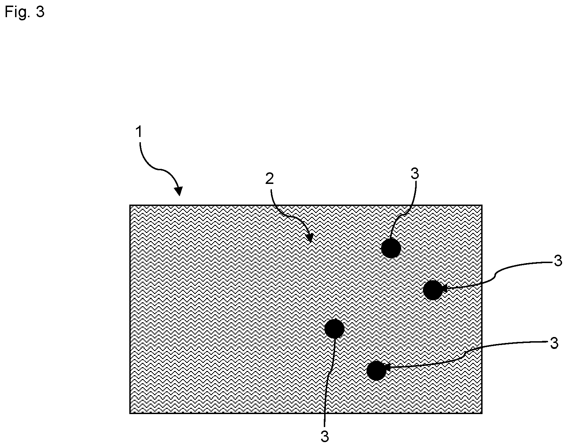

Fig. 1 bis Fig. 4 zeigen Draufsichten von bevorzugten Ausgestaltungen eines Informationsträgers 1. Ein Informationsträger 1 besteht im Wesentlichen aus einem Substrat 2 mit mindestens einer bereichsweise aufgebrachten und elektrisch leitfähigen Schicht, wobei die Schicht die Touch-Struktur 3 ist. Das Substrat 2 ist ein Träger und besteht bevorzugt aus einem Kunststoff, einem Papier, einem Karton, einem Holzwerkstoff, einem Verbundwerkstoff, Glas, Keramik, Textilien, Leder oder einer Kombination davon. Auf dem Substrat 2 ist bereichsweise die elektrisch leitfähige Touch-Struktur 3 aufgebracht.

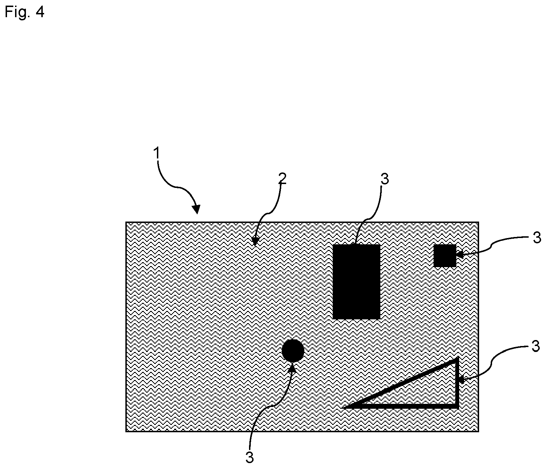

Die Touch-Struktur 3 kann beispielsweise in Form von Kreisen und/oder Rechtecken auf das Substrat 2 aufgetragen sein. Vorteilhafterweise kann die Touch-Struktur 3 auch mit unterschiedlichen geometrischen Figuren (Fig. 1, 2, 3) dargestellt werden, wobei diese auch miteinander kombinierbar sind (Fig. 4).

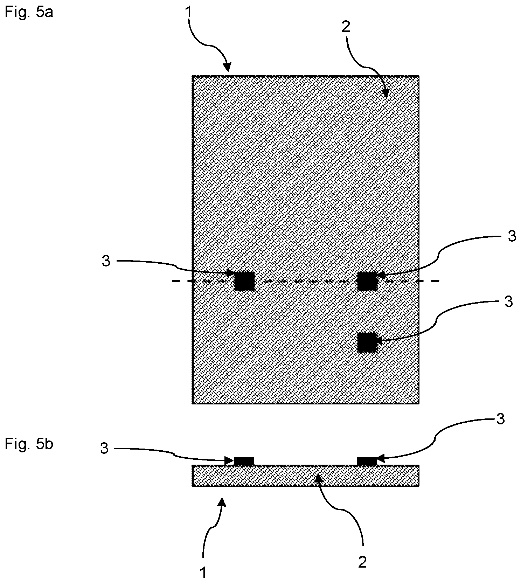

Fig. 5a und Fig. 5b zeigen einen Informationsträger 1 in einer prinzipiellen Schnittdarstellung. Die Erhebung der Touch-Struktur 3 in Fig. 5b dient zur besseren Veranschaulichung. Je nach Herstellungsverfahren für die Touch-Struktur 3 kann diese erhaben (bspw. Siebdruck), oberflächengleich (bspw. Offsetdruck) oder sogar vertieft (bspw. Heißprägen) zum umliegenden Substrat sein.

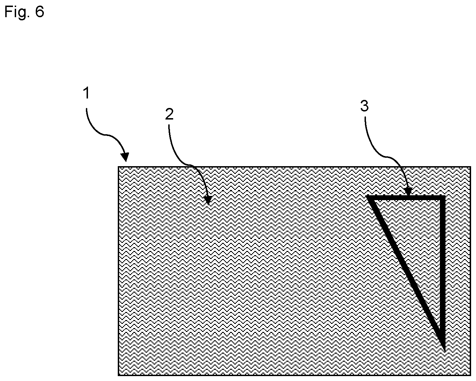

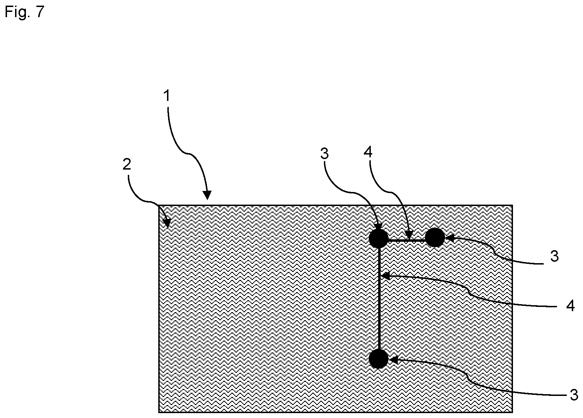

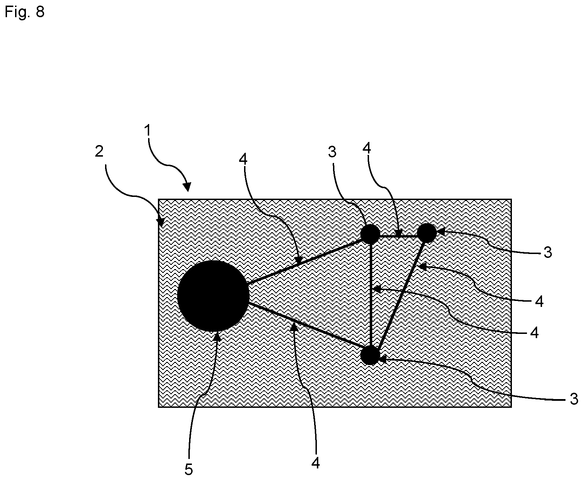

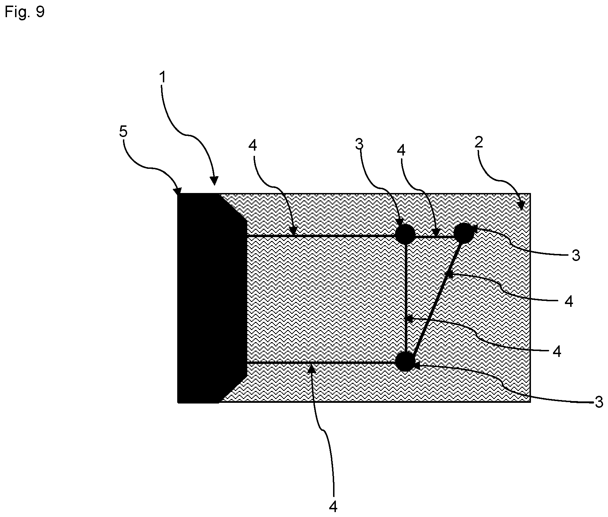

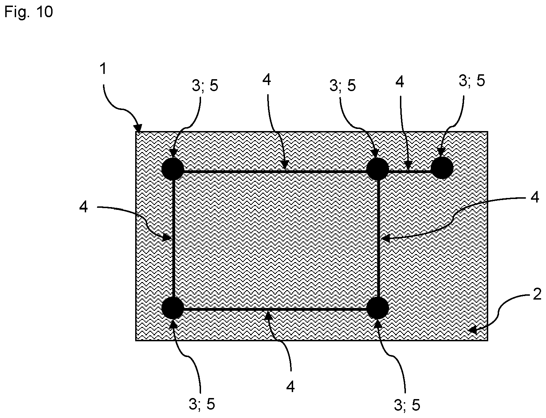

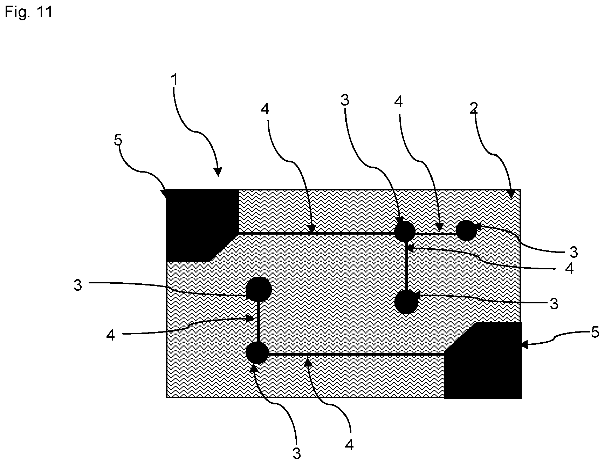

Fig. 6 und Fig. 7 zeigen Informationsträger 1 mit Leiterbahnen 4. Die Teilbereiche der Touch-Struktur 3 können vorteilhafterweise kleiner, gleich (Fig. 6) oder größer (Fig. 7) als die Leiterbahnen 4 sein. In weiteren Ausführungsformen (Fig. 8, 9, 10,11) befindet sich wenigstens ein weiterer Teilbereich der elektrisch leitfähigen Schicht (der Touch-Struktur 3) als Koppelfläche 5 auf dem Substrat 2. Die einzelnen Teilbereiche der Touch-Struktur 3 sind bevorzugt über Leiterbahnen 4 miteinander elektrisch leitend verbunden. Vorteilhafterweise sind die Touch-Struktur 3 und die Leiterbahnen 4 aus der elektrisch leitfähigen Schicht ausgebildet.

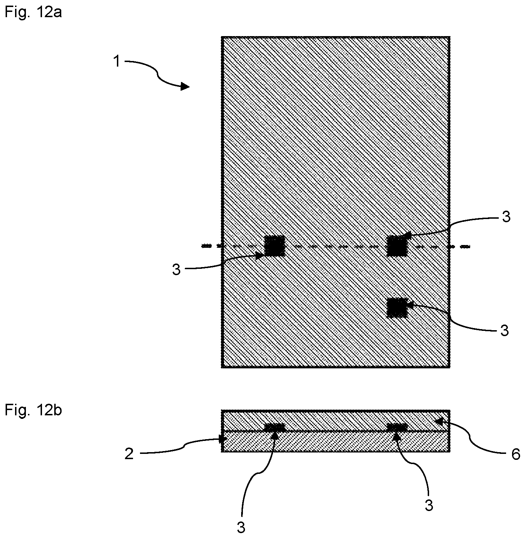

Fig. 12a und Fig. 12b zeigen einen Informationsträger 1 mit einer Deckschicht 6 in einer prinzipiellen Schnittdarstellung. Auf dem Substrat 2 und der elektrisch leitfähigen Touch-Struktur 3 befindet sich wenigstens eine Deckschicht 6, so dass ein kompakter Informationsträger 1 vorliegt und die Touch-Struktur 3 insbesondere nicht beschädigt wird oder von außen einsehbar ist. Die Deckschicht 6 kann ebenfalls als eine Deckplatte ausgestaltet sein.

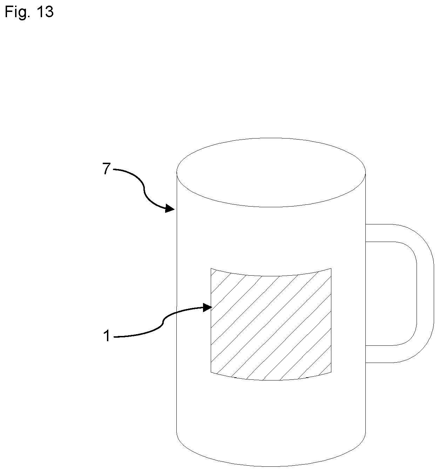

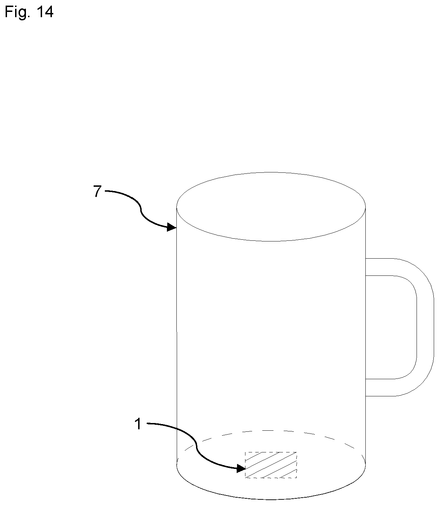

Fig. 13 und Fig. 14 zeigen einen Informationsträger 1 an einem Gegenstand 7. Vorteilhafterweise kann der erfindungsgemäße Informationsträger 1 auf einem Gegenstand 7, beispielsweise einer Tasse anbringbar sein. Hierdurch kann vorteilhafterweise einem Käufer eines Gegenstandes schnell und einfach eine digitale Information mittels des Informationsträgers 1 zukommen. Der Informationsträger 1 ist bevorzugt auf den Gegenstand 7 gedruckt, wobei der Informationsträger 1 auf eine ebene oder unebene Fläche aufgebracht werden kann.

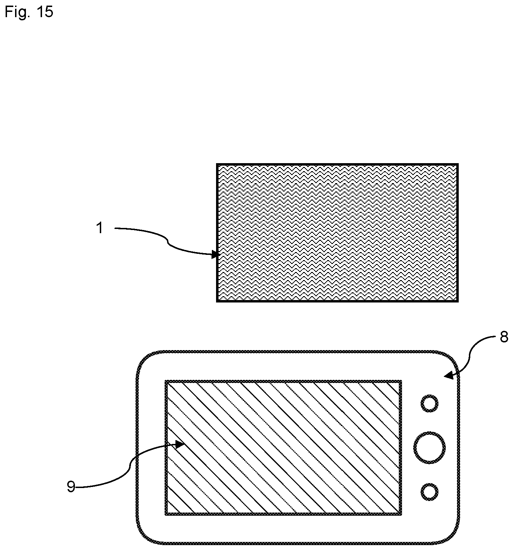

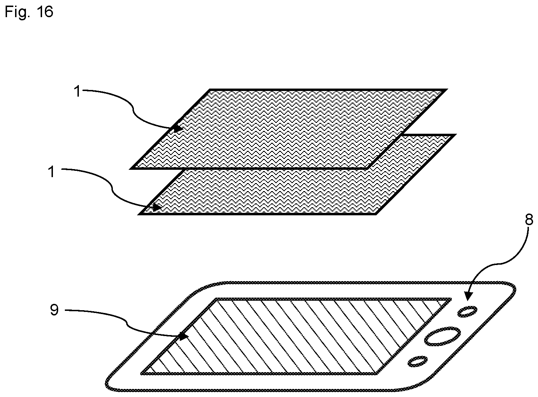

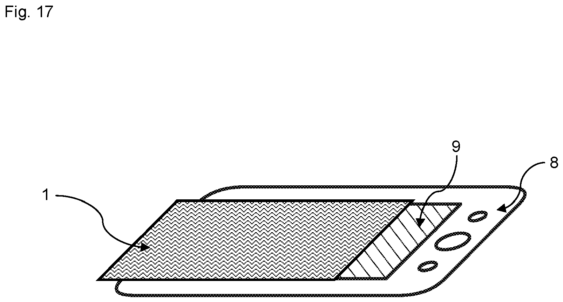

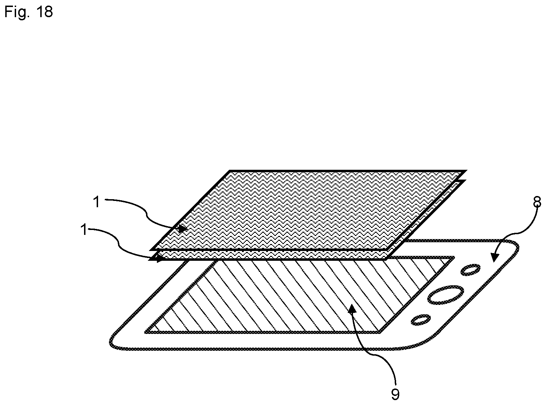

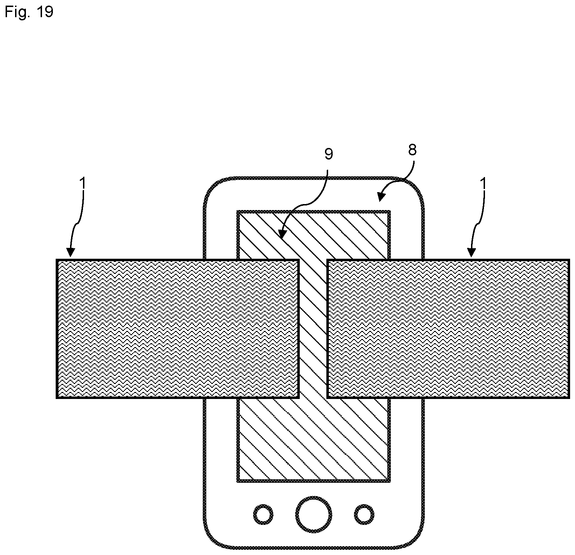

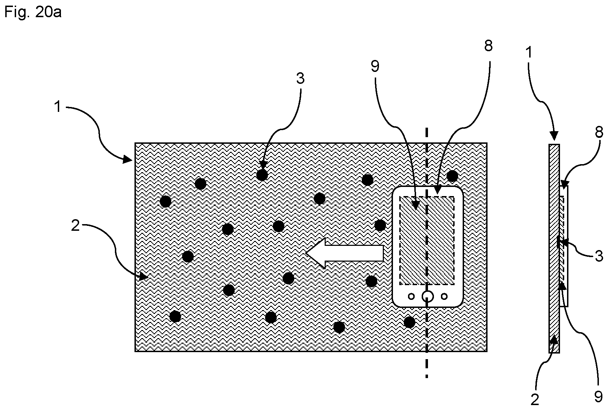

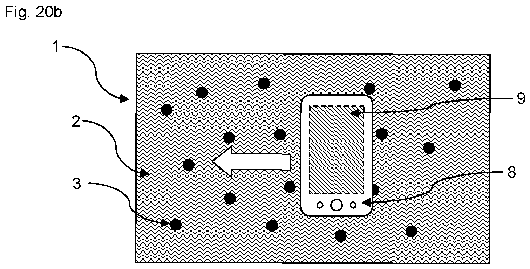

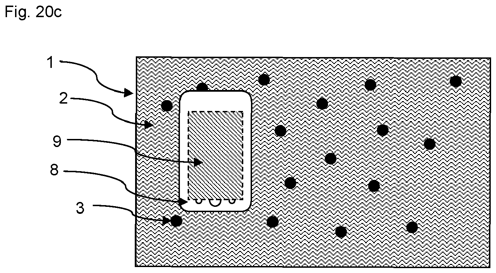

Fig. 15 bis Fig. 20 zeigen eine Interaktion eines oder mehrerer Informationsträger 1 mit einem Flächensensor 9. Der Informationsträger 1 mit den auf ihm gespeicherten Informationen kann mit einem Gerät mit Flächensensor 8, in Kontakt gebracht werden. Das Gerät mit Flächensensor 8 ist bevorzugt ein datenverarbeitendes Gerät. Der Informationsträger 1 kann beispielsweise nur bereichsweise mit dem Flächensensor 9 in Kontakt kommen. Es kann auch bevorzugt sein, dass der Informationsträger 1 nicht auf den Flächensensor 9 gelegt, sondern über diesen bewegt wird. Durch eine unterschiedliche Art und Weise der Kontaktherstellung oder Annäherung kann bevorzugt ein unterschiedliches Ereignis auf dem Flächensensor 9 ausgelöst werden. Außerdem können mehrere Informationsträger 1 mit dem Flächensensor 9 interagieren. In Fig. 20 wird der Flächensensor 9, d. h. das den Flächensensor aufweisende Gerät 8 über einen Informationsträger 1 bewegt, wobei der Informationsträger 1 mehrmals an unterschiedlichen Positionen mit dem Flächensensor 9 in Kontakt oder Annäherung kommen muss, damit die vollständige Information des Informationsträgers 1 auslesbar wird. Hierdurch können größere Informationsmengen in dem Informationsträger 1 gespeichert werden, weil damit der Informationsträger 1 größer als der Flächensensor 9 sein kann. Das Auslesen der Informationen durch das Gerät mit Flächensensor 8 kann bevorzugt durch Wisch-Bewegungen realisiert werden.

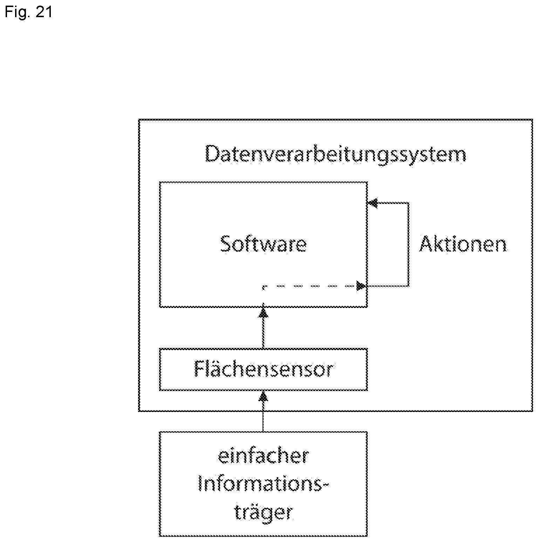

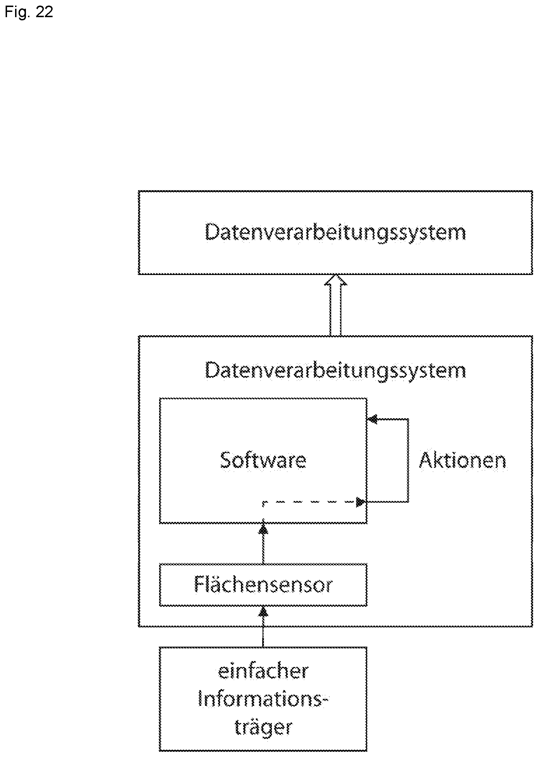

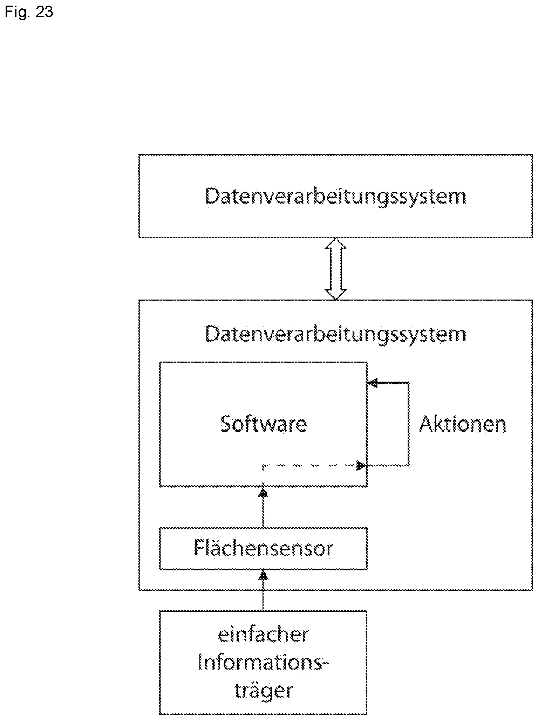

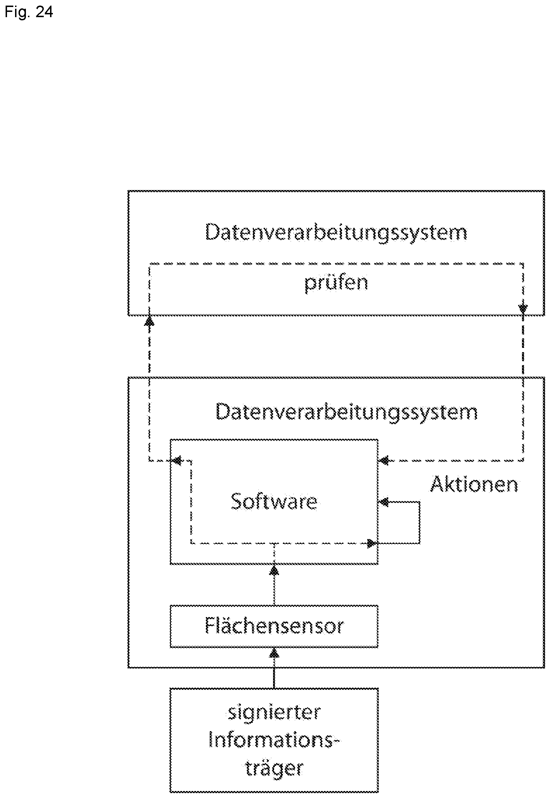

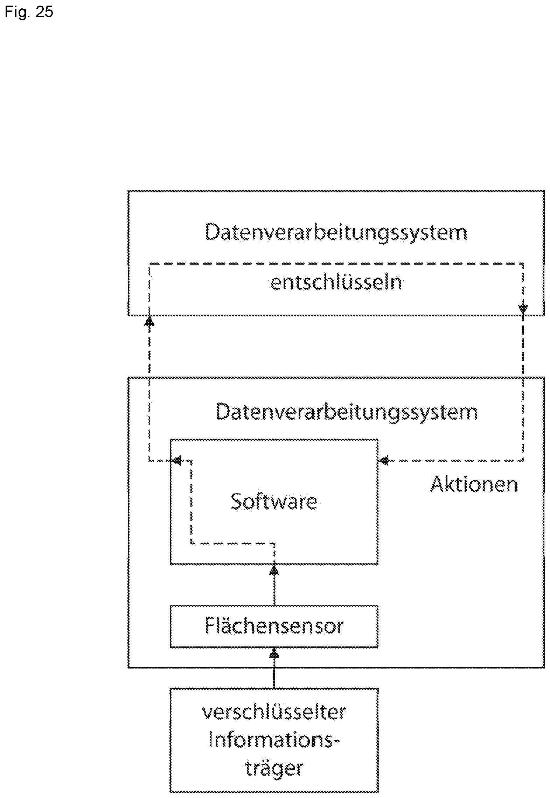

Fig. 21 bis Fig. 25 zeigen bevorzugte Anwendungen eines Informationsträgers. Der Informationsträger kann gemäß Fig. 21 als einfacher Informationsträger genutzt werden, der mit einem Flächensensor interagiert, wodurch bevorzugt ein Ereignis ausgelöst wird. Das Ereignis löst wiederum Aktionen aus, wie beispielsweise die Aktivierung und/oder das Beenden einer Anwendung, das Verändern von numerischen Werten und/oder Texten, das Manipulieren von Grafiken, das Verändern von Datenbeständen oder das Erlangen von Zugriff auf informationstechnische Dienste ohne darauf beschränkt zu sein. Außerdem kann gemäß Fig. 22 über den Flächensensor, beispielsweise in Form eines kapazitiven Touchscreens eines Gerätes, der Programmablauf eines Datenverarbeitungssystems des Gerätes selbst beeinflusst werden. Die ausgelöste Aktion kann einseitig oder beidseitig sein, d. h. es kann eine Aktion ausgelöst werden, die auf ein externes Datenverarbeitungssystem einwirkt, wobei dieses wiederum auf das des datenverarbeitende Gerätes wirkt (siehe Fig. 23). Weiterhin kann der Informationsträger als signierter Informationsträger ausgestaltet sein (siehe Fig. 24), wobei bevorzugt ein Zusammenwirken zwischen dem datenverarbeitenden Gerät, einem Datennetz und einem Datenverarbeitungssystem entsteht. Der signierte Informationsträger kann so beispielsweise über das Internet überprüft und verifiziert werden. Mittels des erfindungsgemäßen Systems wird ein Zugang und/oder die Nutzung eines Datenverarbeitungssystems ermöglicht. Dazu ist das Gerät mittels des Informationsträgers über ein Datennetz mit einem Datenverarbeitungssystem verbunden. Nach Prüfung der Signatur im Datenverarbeitungssystem ist der Zugang über das Gerät gegeben. Weiterhin kann gemäß der Fig. 25 der Informationsträger auch verschlüsselt vorliegen, wobei dieser insbesondere mit einem Gerät, einem Datennetz und einem Datenverarbeitungssystem zusammenwirkt. Über den Flächensensor des Geräts wird eine Nutzung eines Datenverarbeitungssystems ermöglicht. Dazu ist das Gerät mittels eines Datennetzes mit dem Datenverarbeitungssystem verbunden. Nach positiver Prüfung des Informationsträgers im Datenverarbeitungssystem ist der Zugang über das Gerät gegeben.

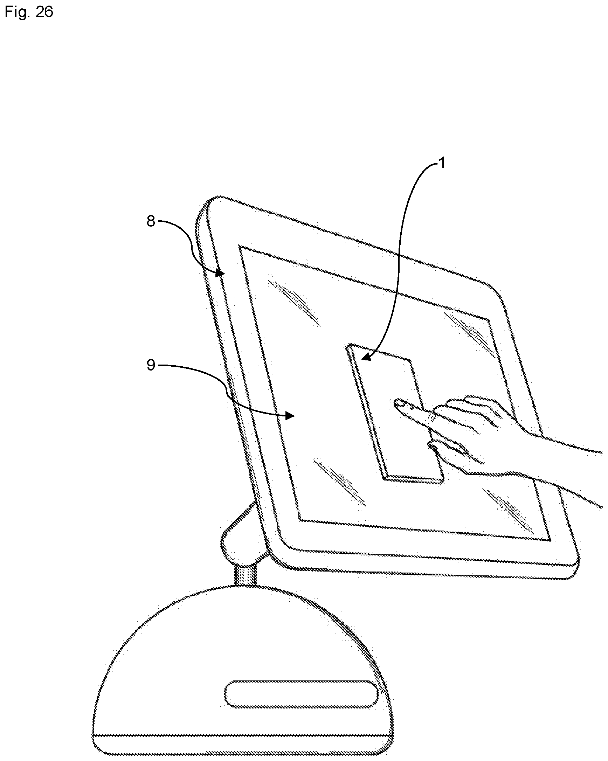

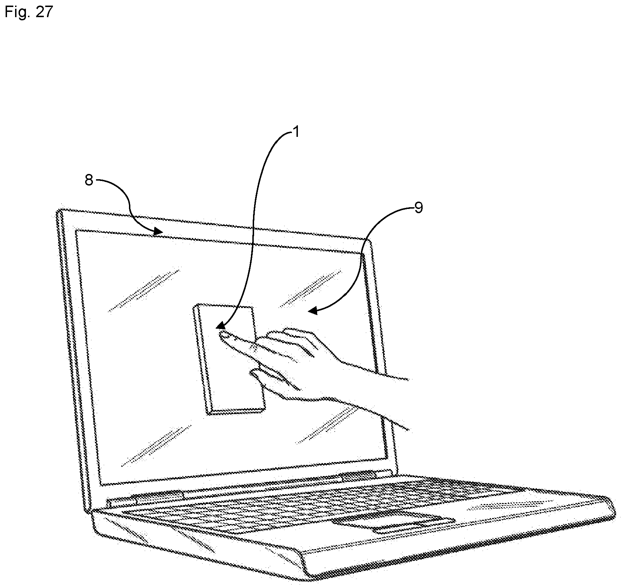

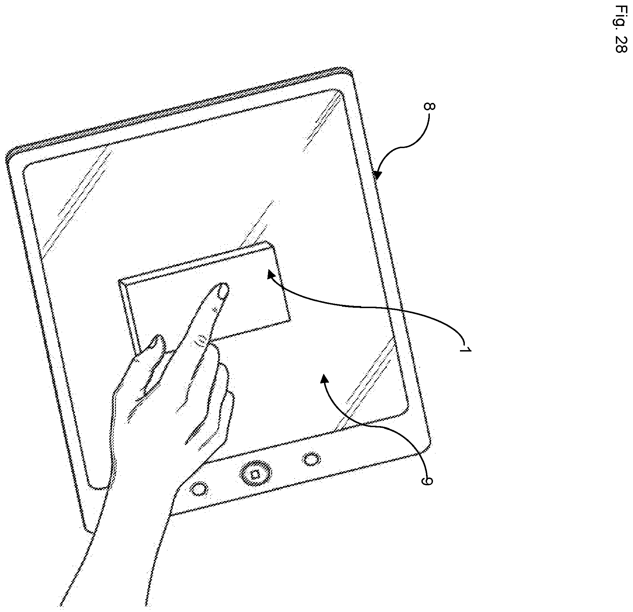

Die Fig. 26 bis Fig. 28 zeigen die Verwendung des Informationsträgers 1 an unterschiedlichen Geräten 8, wobei alle Geräte 8 einen Flächensensor 9, insbesondere einen kapazitives Touch-Screen aufweisen. Der Informationsträger 1 umfasst im Wesentlichen ein Substrat mit mindestens einer bereichsweise aufgebrachten elektrisch leitfähigen Schicht, wobei die Schicht die Touch-Struktur ist. Das Substrat ist ein Träger und besteht bevorzugt aus einem Kunststoff, einem Papier, einem Karton, einem Holzwerkstoff, einem Verbundwerkstoff, Glas, Keramik, Textilien, Leder oder einer Kombination davon. Auf dem Substrat ist bereichsweise die elektrisch leitfähige Touch-Struktur aufgebracht. Erfindungsgemäß ist eine Touch-Struktur insbesondere eine strukturiert aufgebrachte Schicht aus leitfähigem Material. Der Informationsträger 1 wird bevorzugt mittels eines Transferfolienverfahrens hergestellt, wodurch ein sehr kostengünstiger Informationsträger 1 bereitgestellt werden kann. Der Informationsträger 1 kann beispielsweise als Gutschein verwendet werden. Der Empfänger des Gutscheins - des Informationsträger 1 - bringt den Informationsträger 1 in Kontakt mit einem Gerät mit Flächensensor 8. Hierbei kann es sich beispielsweise um einen PC (siehe Fig. 26), einen Laptop (Fig. 27) oder einen Tablet-PC (Fig. 28) handeln. Ein kapazitiver Flächensensor ist insbesondere eine physikalische Schnittstelle zur Erfassung von elektrischen Kapazitäten und/oder Kapazitätsunterschieden innerhalb von Teilbereichen einer definierten Fläche. Flächensensoren beinhaltende Geräte umfassen beispielsweise Smartphones, Handys, Displays, Tablet-PCs, Tablet-Notebooks, Touchpad-Geräte, Grafiktabletts, Fernseher, PDAs, MP3-Player, Trackpads und/oder kapazitive Eingabegeräte. Ein solcher Flächensensor kann beispielsweise auch Bestandteil von Eingabegeräten als Touchscreen, Touchpad oder Grafiktablett sein. Touchscreens sind auch als Tastschirm oder Sensorbildschirm bekannt. Derartige Eingabegeräte werden unter anderem in Smartphones, PDAs, Touchdisplays oder Notebooks eingesetzt. Der Informationsträger 1 kann mit dem Flächensensor 9 in Kontakt gebracht werden oder sich diesem annähern, um hierdurch ein Ereignis auszulösen. Das Ereignis kann beispielsweise darin bestehen, dass der Informationsträger 1 ein Programm auf dem Gerät 8 auslöst, welches beispielsweise dem Empfänger des Gutscheins eine bestimmte Webpage anzeigt. Der Empfänger erhält eine Gutschrift über einen definierten Betrag und kann diesen für Produkte, die auf der Webpage präsentiert werden, ausgeben. Vorteilhafterweise erfolgt die Interaktion bzw. die Erkennung des Informationsträgers 1 durch das Gerät 8, wie beispielsweise einem PC, Laptop oder Tablet-PC sehr schnell.

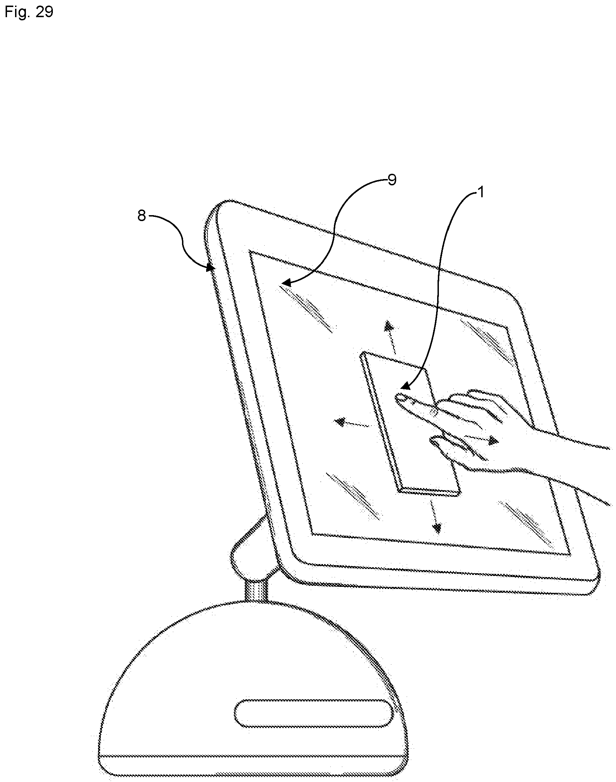

Fig. 29 zeigt eine Bewegung eines Informationsträgers an einem Flächensensor. Der Informationsträger 1 kann mit einem Gerät mit Flächensensor 8 bereichsweise in Kontakt gebracht oder zumindest an den Flächensensor 9 angenähert werden. Auf dem Substrat des Informationsträgers 1 befindet sich mindestens eine bereichsweise aufgebrachte elektrisch leitfähige Schicht, wobei wenigstens ein Bereich der elektrisch leitfähigen Schicht ein Teilbereich ist. Der oder die Teilbereich(e) werden im Sinne der Erfindung auch als Touch-Struktur bezeichnet. Die Form, Orientierung, Anzahl, Ausrichtung, Abstand und/oder Position der Touch-Struktur oder deren Teilbereiche bilden bevorzugt die Information, so dass bei mindestens bereichsweiser Positionierung des Informationsträgers 1 an dem Flächensensor 9 oder über eine relative Bewegung wenigstens eines Bereiches des Informationsträgers 1 gegenüber dem Flächensensor 9 wenigstens ein Ereignis ausgelöst wird. Eine bereichsweise Positionierung des Informationsträgers 1 auf dem Flächensensor 9 bedeutet im Sinne der Erfindung, dass insbesondere mindestens ein Bereich des Informationsträgers 1 mit mindestens einem Bereich des Flächensensors 9 in Kontakt steht. Bevorzugte Bewegungen des Informationsträgers 1 an dem Flächensensor 9 sind in Fig. 29 als Pfeile angedeutet. Die Bewegung kann in alle Richtungen auf dem Flächensensor 9 erfolgen - wie beispielsweise horizontal oder vertikal - und kann beispielsweise in Form einer Kurve, eines Kreises oder einer Geraden ausgeführt werden. Durch den Kontakt oder die Annäherung wird eine kapazitive Wechselwirkung zwischen dem Informationsträger 1 und dem Flächensensor 9 erreicht und die Touch-Struktur des Informationsträgers 1 wird für ein mit dem Flächensensor 9 verbundenes Datenverarbeitungssystem auswertbar und kann dadurch mit dem Informationsträger 1 assoziierte Ereignisse auslösen.

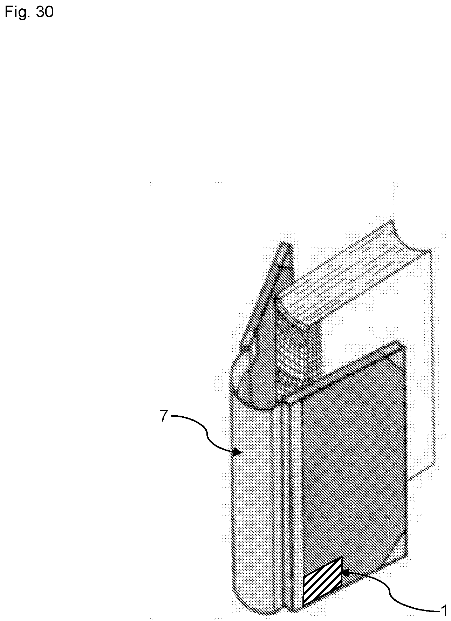

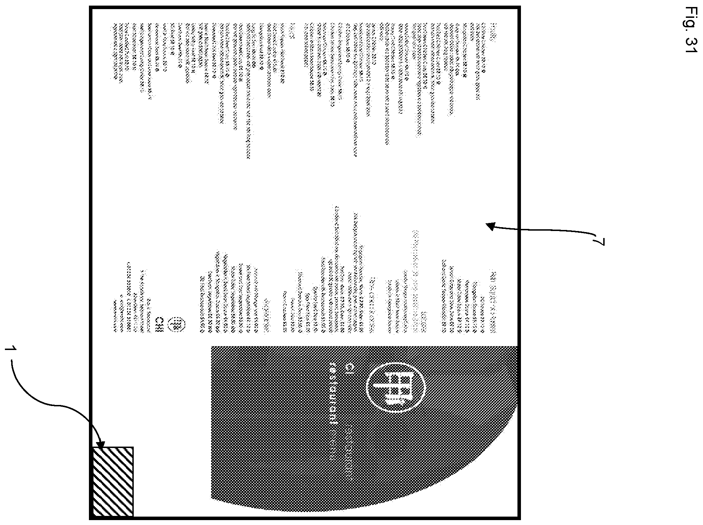

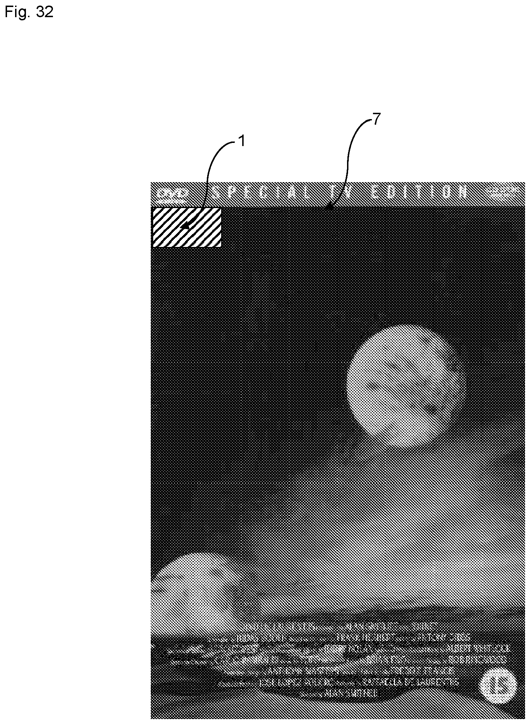

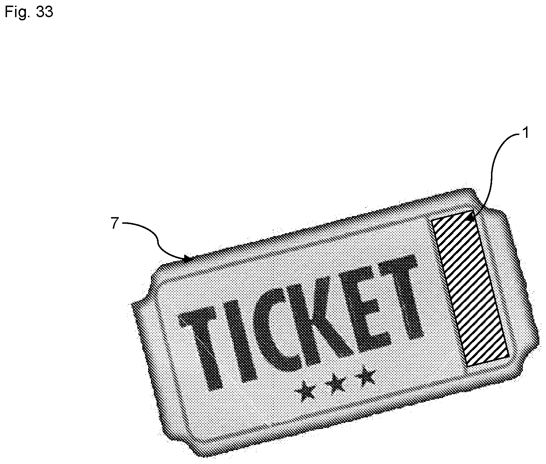

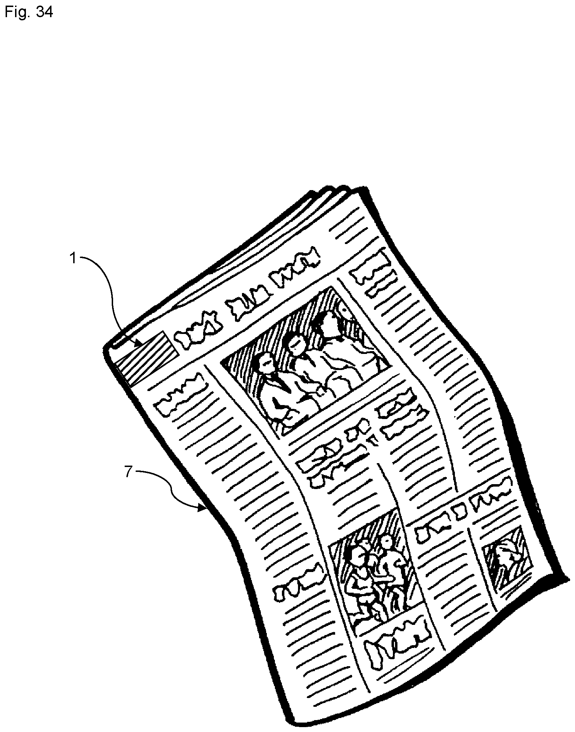

Fig. 30 bis Fig. 34 zeigen bevorzugte Verwendungen eines Informationsträgers. Der Informationsträger 1 kann vielseitig eingesetzt und verwendet werden. Der Informationsträger 1 kann an unterschiedlichen Gegenständen 7 angebracht oder auf diese gedruckt werden. Beispielsweise ist es bevorzugt, den Informationsträger 1 auf einem Gegenstand 7, wie beispielsweise einem Buch anzubringen (siehe Fig. 30). Der Informationsträger 1 kann auch in dem Buchband oder an einer anderen Stelle des Buches angebracht sein, wobei der Informationsträger 1 auf das Buch gedruckt oder auf diesem anderweitig angebracht werden kann. Ein Interessent des Buches kann ein Gerät mit einem Flächensensor, beispielsweise ein Smartphone mit dem Informationsträger 1 in Kontakt oder in dessen Nähe bringen, wodurch auf dem Smartphone ein Ereignis und bevorzugt eine Aktion ausgelöst wird. Die Aktion kann ein internetfähiges Smartphone beispielsweise auf eine Webpage weiterleiten, auf der dem Interessenten eine Leseprobe des Buches gratis zur Verfügung steht. Der Interessent kann sich somit vor dem Kauf des Buches über dessen Inhalt informieren. Der Interessent oder ggf. Käufer des Buches kann aber auch mittels des Informationsträgers 1 an Informationen über den Autor des Buches gelangen und über weitere seiner Werke informiert werden. In Fig. 31 ist eine weitere bevorzugte Verwendung des Informationsträgers 1 dargestellt. Hierbei ist der Informationsträger 1 auf einem anderen Gegenstand 7, nämlich einer Speisekarte aufgebracht. Der Informationsträger 1 kann auf die Speisekarte gedruckt oder anderweitig auf dieser befestigt werden. Bei einem Restaurantbesuch wird die Speisekarte einem Besucher vorgelegt. Der Besucher kann sich für ein Gericht auf der Speisekarte entscheiden und zusätzlich den auf der Speisekarte aufgebrachten Informationsträger 1 mit einem Gerät mit einem Flächensensor, beispielsweise mit seinem Smartphone auslesen. Hierfür bringt er das Gerät mit dem Informationsträger 1 in Kontakt oder in dessen Nähe, wodurch z. B. auf dem Smartphone ein Ereignis und eine Aktion ausgelöst wird. Die Aktion kann darin bestehen, dass der Besucher weitere Informationen über das gewählte Gericht angezeigt bekommt. Die Informationen können Zutaten, weitere Inhaltsstoffe oder Allergiehinweise umfassen. Der Besucher kann auch ggf. das Rezept zur Zubereitung des Gerichtes einsehen und auf seinem Gerät speichern, wofür das Restaurant beispielsweise eine Gebühr erheben kann. Auch kann der Besucher mittels des Informationsträgers 1 über Veranstaltungen, die in dem Restaurant stattfinden, informiert werden. Vorteilhafterweise können die Veranstaltungen, an denen der Besucher interessiert ist, direkt in einer Kalenderanwendung auf dem Smartphone gespeichert werden. Außerdem wird die Adresse des Restaurants vorteilhafterweise in eine Adressenverwaltungsanwendung auf dem Smartphone eingetragen. Fig. 32 zeigt eine weitere bevorzugte Verwendung des Informationsträgers 1. Hierbei ist der Informationsträger 1 auf einem Gegenstand 7, beispielsweise einer DVD-Hülle aufgebracht. Der Informationsträger 1 kann vorteilhafterweise auf verschiedene Verpackungen aufgedruckt oder an diesen anderweitig angebracht sein. Ein Interessent, der die DVD erwerben möchte, kann ein Gerät mit einem Flächensensor, beispielsweise sein Smartphone mit dem Informationsträger 1 in Kontakt bringen oder in dessen Nähe führen. Der Informationsträger 1 löst ein Ereignis bzw. eine Aktion auf dem Smartphone aus, wodurch der Interessent Informationen über das Produkt erhält. Beispielsweise kann ein internetfähiges Smartphone mittels des Informationsträgers 1 auf eine Webpage geleitet werden, auf der sich der Interessent einen Trailer des Filmes ansehen kann, den er ggf. kaufen möchte. Auch Informationen über die Schauspieler, verfügbare Sprachen, usw. stehen dem Interessenten zur Verfügung. Ist der Informationsträger 1 auf einer Musik CD aufgebracht, kann der Interessent nach Auslesen des Informationsträgers 1 mittels eines Smartphones, die Musik CD Probe hören. Es kann auch vorteilhaft sein, dass der Informationsträger 1 derart an oder in der Verpackung angebracht ist, dass er erst nach Kauf des Produktes für den Käufer zugänglich wird. Der Informationsträger 1 eröffnet dem Käufer dann Zugang zu Zusatzmaterial, was beispielsweise über eine Webpage einsehbar ist. Auf der Webpage können auch Merchandising Produkte für den erworbenen Film angeboten werden. Fig. 33 stellt eine weitere bevorzugte Verwendung des Informationsträgers 1 dar. Der Informationsträger 1 ist auf einem Gegenstand 7, beispielsweise einem Ticket angebracht. Das Ticket kann z. B. ein Konzertticket, ein Theaterticket oder ein Kinoticket sein, mit dem eine Person Zugang zu der entsprechenden Vorstellung erhält. Der Informationsträger 1 kann zum Einen als Zugangsberechtigung oder Echtheitszertifikat genutzt werden, so dass der Informationsträger 1 von einem Lesegerät oder einem Gerät mit einem Flächensensor eingelesen wird und erst nach einer positiven Validierung einer Person Zugang zu der Vorstellung ermöglicht. Zum Anderen kann der Informationsträger 1 dazu genutzt werden, dass die Person ein Gerät mit einem Flächensensor mit dem Informationsträger 1 in Kontakt oder in dessen Nähe bringt und auf dem Gerät ein Ereignis bzw. eine Aktion ausgelöst wird. Die Aktion kann beispielsweise darin bestehen, dass die Person Zugang zu einer Webpage erhält, auf der Aufzeichnungen des Konzertes oder Informationen über die Musiker einsehbar sind. Außerdem können mittels des Informationsträgers 1, die Daten des Konzertes automatisch in eine Kalenderanwendung und die Adresse des Veranstaltungsortes automatisch in eine Adressenverwaltungsanwendung eingetragen werden. Der Person kann so beispielsweise der Weg zu dem Veranstaltungsort auf einem Smartphone angezeigt werden. Fig. 34 zeigt eine weitere bevorzugte Verwendung eines Informationsträgers 1, der auf einem Gegenstand 7 aufgebracht ist, wobei der Gegenstand eine Tageszeitung sein kann. Der Informationsträger 1 kann auf eine Zeitung gedruckt sein oder dieser z. B. beiliegen. Ein Käufer der Zeitung kann den Informationsträger 1 mit einem Gerät mit Flächensensor auslesen, wodurch dem Käufer beispielsweise weitere Informationen zugänglich sind. Der Käufer erhält Zugang zu einer Webpage, auf der z. B. Videos zu den Artikeln oder Interviews einsehbar sind. Weiterhin ist es vorteilhaft, wenn der Informationsträger 1 als Gutschein fungiert. Das heißt, der Käufer der Zeitung kann den Informationsträger 1 auslesen und erhält ggf. ein Probeabonnement für die Zeitung. Der Informationsträger 1 kann auch für Werbezwecke genutzt werden, indem weitere Informationsträger 1 der Zeitung beilegen, die Werbung für Dritte beinhalten. Zum Beispiel kann der Käufer der Zeitung einen Informationsträger 1 mit einem Smartphone auslesen und erhält Zugang zu einer Webpage des Dritten, auf der dessen Produkte angeboten werden. Ggf. wird die Adresse eines Ladens des Dritten direkt auf dem Smartphone gespeichert. Außerdem können dem Käufer mittels des Informationsträgers 1 Angebote von Waren des Dritten mitgeteilt werden. Es kann auch vorteilhaft sein, wenn ein potentieller Käufer, vor dem Kauf der Zeitung den Informationsträger 1 einlesen kann und mittels eines Smartphones eine Übersicht über die enthaltenen Artikel erhält. Dem Käufer kann bereits beim Besuch eines Kiosks, vor Kauf einer Zeitung, eine Leseprobe angeboten werden.

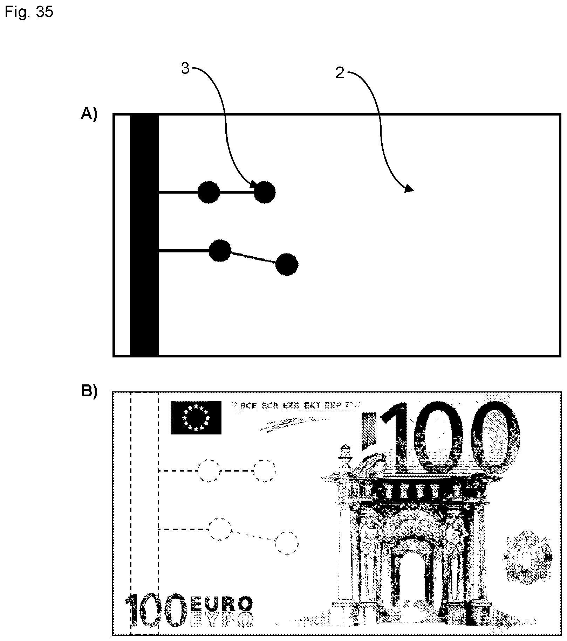

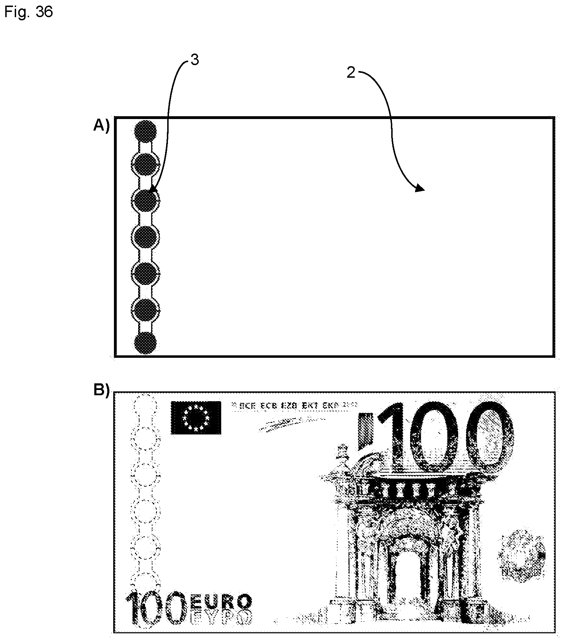

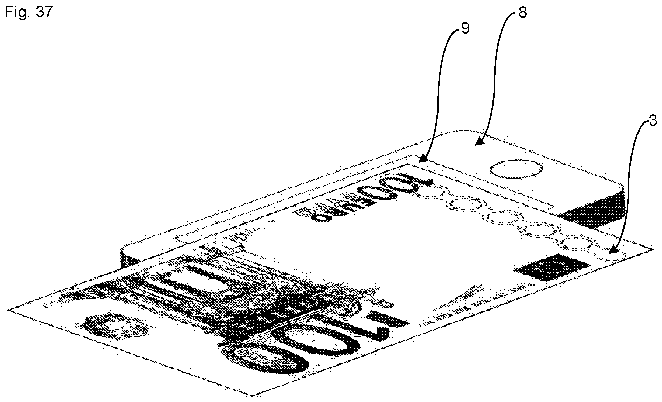

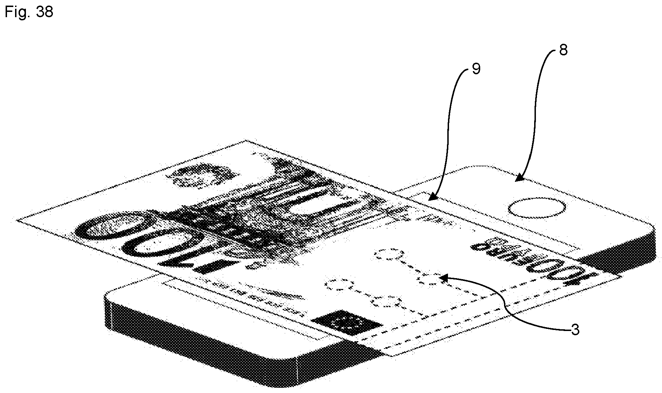

Fig. 35 bis Fig. 38 zeigen eine Verwendung des Informationsträgers als Sicherheitsmerkmal auf einem Geldschein. Der Informationsträger 1 kann beispielsweise in einer Banknote, d.h. einem Geldschein verwirklicht sein. Hierbei kann das Papier des Geldscheins als Substrat 2 fungieren, auf das der Informationsträger 1, bzw. die Touch-Struktur 3 aufgebracht ist. Der Informationsträger kann somit als Sicherheitsmerkmal dienen, welches für einen Benutzer des Geldscheins nicht sichtbar ist. Es kann jedoch auch bevorzugt sein, dass die Touch-Struktur 3 derart auf den Geldschein gedruckt ist, dass sie für einen Benutzer vollständig oder teilweise sichtbar ist, wodurch dem Benutzer aufgezeigt wird, dass der Geldschein über zahlreiche Sicherheitsmerkmale verfügt. Dies kann demnach als sichtbarer Kopierschutz der Abschreckung dienen. Der Informationsträger 1 kann mittels einem Lesegerät oder einem Flächensensor 9 ausgelesen werden, so dass hierdurch die Echtheit des Geldscheins verifiziert wird. Der Flächensensor 9 (z. B. ein Touchscreen) kann Bestandteil eines, einen Flächensensor 9 aufweisenden elektrischen Gerätes 8 sein. Außerdem können beispielsweise sehbehinderten Personen entsprechende Lesegeräte oder Applikationen auf einem, einen Flächensensor beinhalteten Gerät 8 zur Verfügung gestellt werden, wodurch eine Verifikation aber auch Zählung von Geldscheinen ermöglicht wird. Hierbei könnte der Informationsträger 1 auf dem Geldschein den Wert dessen codieren. Der Geldschein mit dem Informationsträger 1 wird auf den Flächensensor 9 aufgelegt oder mittels einer Bewegung über ihn gezogen, wodurch der Informationsträger 1 von dem Flächensensor 9 gelesen und datentechnisch weiterverarbeitet wird (z. B. um die Echtheit zu verifizieren).

**Bezugszeichenliste**

1 Informationsträger
2 Substrat
3 Touch-Struktur
4 Leiterbahn
5 Koppelfläche
6 Deckschicht
7 Gegenstand
8 Gerät mit Flächensensor
9 Flächensensor

**Patentansprüche**

1. Kapazitiver Informationsträger (1),
**dadurch gekennzeichnet, dass**
auf einem elektrisch nicht leitfähigen Substrat (2) mindestens bereichsweise mindestens eine elektrisch leitfähige Schicht als Touch-Struktur (3) angeordnet ist umfassend

    a. mindestens zwei Touch-Punkte und mindestens eine Leiterbahn (4)
    oder
    b. mindestens einen Touch-Punkt, mindestens eine Koppelfläche (5) und mindestens eine Leiterbahn (4),

wobei der Touch-Punkt die Eigenschaft einer Fingerkuppe nachbildet, die Koppelfläche Fremdkapazitäten zur Erhöhung der wirksamen elektrischen Kapazität der Touch-Struktur (3) ankoppelt und die Leiterbahn (4) eine elektrische Verbindung zwischen zwei Touch-Punkten oder zwischen einem Touch-Punkt und einer Koppelfläche (5) bildet.

2. Kapazitiver Informationsträger (1) nach Anspruch 1 hergestellt unter Verwendung von elektrisch leitfähiger Farbe oder Tinte oder hergestellt durch ein Transferfolienverfahren, wobei das Transferfolienverfahren folgende Schritte umfasst:

   a. Bereitstellung einer Transferfolie auf einer Rolle, wobei die Transferfolie eine Trägerfolie und eine zumindest bereichsweise darauf befindlichen elektrisch leitfähigen Transferschicht umfasst,
   b. Bereitstellung eines elektrisch nicht leitfähigen Substrates,
   c. Bereitstellung eines Klebers,
   d. strukturierte Aufbringung des Klebers gemäß c) auf das Substrat und/oder auf die Transferfolie,
   e. strukturierte Aufbringung der Transferfolie auf das Substrat (2)

wobei auf dem elektrisch nicht leitfähigen Substrat mindestens bereichsweise eine elektrisch leitfähige Schicht als Touch-Struktur (3) angeordnet ist.

3. Verfahren zur Herstellung eines kapazitiven Informationsträgers (1), umfassend die folgenden Schritte:

   a. Bereitstellung einer Transferfolie auf einer Rolle, wobei die Transferfolie eine Trägerfolie und eine zumindest bereichsweise darauf befindlichen elektrisch leitfähigen Transferschicht umfasst,
   b. Bereitstellung eines elektrisch nicht leitfähigen Substrates,
   c. Bereitstellung eines Klebers,
   d. strukturierte Aufbringung des Klebers gemäß c) auf das Substrat und/oder auf die Transferfolie

wobei auf dem elektrisch nicht leitfähigen Substrat mindestens bereichsweise eine elektrisch leitfähige Schicht als Touch-Struktur (3) angeordnet ist umfassend

   a. mindestens zwei Touch-Punkte und mindestens eine Leiterbahn (4)
   oder
   b. mindestens einen Touch-Punkt, mindestens eine Koppelfläche (5) und mindestens eine Leiterbahn (4),

wobei der Touch-Punkt die Eigenschaft einer Fingerkuppe nachbildet, die Koppelfläche Fremdkapazitäten zur Erhöhung der wirksamen elektrischen Kapazität der Touch-Struktur (3) ankoppelt und die Leiterbahn (4) eine elektrische Verbindung zwischen zwei Touch-Punkten oder zwischen einem Touch-Punkt und einer Koppelfläche (5) bildet.

4. Kapazitiver Informationsträger (1) hergestellt nach dem Verfahren nach Anspruch 3.

5. Kapazitiver Informationsträger (1) nach Anspruch 1, 2 oder 4,
   **dadurch gekennzeichnet, dass**
   auf einem elektrisch nicht leitfähigen Substrat (2) mindestens eine elektrisch leitfähige, die Anordnung und/oder Eigenschaften von Fingerkuppen nachbildende, Touch-Struktur (3) angeordnet ist.

6. Kapazitiver Informationsträger (1) nach Anspruch 5,
   **dadurch gekennzeichnet, dass**
   der Kleber ein elektrisch leitfähiger Kleber ist.

7. Kapazitiver Informationsträger (1) nach einem oder mehreren der Ansprüche 1, 2, 4, 5 und/oder 6,
   **dadurch gekennzeichnet, dass**
   mindestens die Touch-Struktur (3) mit einer weiteren Schicht bedeckt ist.

8. Kapazitiver Informationsträger (1) nach Anspruch 7,
   **dadurch gekennzeichnet, dass**
   die die Touch-Struktur (3) bedeckende weitere Schicht eine Papierschicht, eine Folienschicht, eine Farbschicht, eine Lackschicht und/oder Kombinationen derer ist.

9. Kapazitiver Informationsträger (1) nach einem oder mehreren der Ansprüche 1, 2, 4, 5, 6, 7 und/oder 8,
   **dadurch gekennzeichnet, dass**

dieser wenigstens eine, das Substrat (2) ganz oder teilweise überdeckende Deckschicht (6) aufweist.

10. Kapazitiver Informationsträger (1) nach einem oder mehreren der Ansprüche 1, 2, 4, 5, 6, 7, 8 und/oder 9,
**dadurch gekennzeichnet, dass**
der Informationsträger (1) mit einem Gegenstand (7) verbunden ist oder der Gegenstand (7) selbst als Substrat (2) dient.

11. Kapazitiver Informationsträger (1) nach einem oder mehreren der Ansprüche 1, 2, 4, 5, 6, 7, 8, 9 und/oder 10,
**dadurch gekennzeichnet, dass**
die aufgebrachte Touch-Struktur (3) bereichsweise, mittels additiver und/oder subtraktiver Verfahren, bevorzugt durch Inkjetverfahren und besonders bevorzugt durch Laserverfahren in ihrer Strukturierung veränderbar ist.

12. System zur Erfassung von Informationen, umfassend:

    a. mindestens einen kapazitiven Informationsträger (1) nach einem oder mehreren der Ansprüche 1, 2, 4, 5, 6, 7, 8, 9, 10 und/oder 11,
    b. mindestens einen kapazitiven Flächensensor (9),

wobei durch einen statischen und/oder dynamischen Kontakt zwischen a. und b. eine kapazitive Wechselwirkung erreicht wird.

13. System nach Anspruch 12,
**dadurch gekennzeichnet, dass**
durch die kapazitive Wechselwirkung, die Touch-Struktur (3) des Informationsträgers (1) für ein mit dem Flächensensor (9) verbundenes Datenverarbeitungssystem auswertbar wird und dieses mit dem Informationsträger (1) assoziierte Ereignisse auslösen kann.

14. System nach einem der Ansprüche 12 oder 13 ,
**dadurch gekennzeichnet, dass**
der Flächensensor (9) und/oder das Flächensensor beinhaltende Gerät (8) kapazitive Touchscreens und/oder Touchpads umfasst und ausgewählt ist aus der Gruppe umfassend Smartphones, Handys, Displays, Tablet-PCs, Tablet-Notebooks, Touchpad-Geräten, Grafiktabletts, Fernseher, PDAs, MP3-Player, Trackpads und kapazitive Eingabegeräte.

15. Verwendung eines Systems nach einem oder mehreren der Ansprüche 12, 13 und/oder 14,
**dadurch gekennzeichnet, dass**
mindestens ein Informationsträger (1) mit mindestens einem Flächensensor (9) mindestens bereichsweise in Kontakt ist.

16. Verwendung eines System nach einem oder mehreren der Ansprüche 12, 13 und/oder 14,
**dadurch gekennzeichnet, dass**
der Flächensensor (9) in einer Bewegung relativ zum Informationsträger (1) fortschreitend vollständig oder teilweise Informationen von dem Informationsträger (1) erhält.

17. Verwendung eines System nach einem oder mehreren der Ansprüche 12, 13 und/oder 14,
**dadurch gekennzeichnet, dass**
mehrere Informationsträger (1) in Kombination, insbesondere nebeneinander und/oder übereinander und/oder zeitlich nacheinander, gelesen werden.

18. Verwendung eines kapazitiven Informationsträgers nach Anspruch 1, 2 oder 4 zur Erfassung von Informationen, umfassend

    a. Bereitstellung des kapazitiven Informationsträgers (1) und mindestens einen kapazitiven Flächensensor (9),
    b. In Kontakt bringen mindestens eines Informationsträgers (1) mit dem mindestens einen Flächensensor (9), wobei der Kontakt statisch und/oder dynamisch sein kann und
    c. Auslösen einer kapazitiven Wechselwirkung zwischen Flächensensor (9) und Informationsträger (1), wobei durch die kapazitive Wechselwirkung die Touch-Struktur (3) des Informationsträgers (1) für ein mit dem Flächensensor (9) verbundenem Datenverarbeitungssystem auswertbar wird und mit dem Informationsträger (1) assoziierte Ereignisse auslösen kann.

**19.** Verwendung von mindestens einem Informationsträger (1) zur Erfassung von Informationen nach Anspruch 18, **dadurch gekennzeichnet, dass** der Informationsträger (1) einem Datensatz in einem Datenverarbeitungssystem zugeordnet ist und der Datensatz konstant bleibt.

**20.** Verwendung von mindestens einem Informationsträger (1) zur Erfassung von Informationen nach Anspruch 18, **dadurch gekennzeichnet, dass** der Informationsträger (1) einem Datensatz in einem Datenverarbeitungssystem zugeordnet ist und sich der Datensatz verändert.

**21.** Verwendung von mindestens einem Informationsträger (1) zur Erfassung von Informationen nach einem oder mehreren der Ansprüche 18, 19 und/oder 20, **dadurch gekennzeichnet, dass** der Informationsträger (1) in Verbindung mit einem Flächensensor (9) über die Touch-Struktur (3) einer Aktion eines Datenverarbeitungssystem zugeordnet wird oder diese auslöst.

**22.** Verwendung von mindestens einem Informationsträger (1) zur Erfassung von Informationen nach einem oder mehreren der Ansprüche 18, 19, 20 und/oder 21, **dadurch gekennzeichnet, dass** mindestens zwei Informationsträger (1) kombiniert werden und durch die Kombination ein Ereignis ausgelöst wird.

**Claims**

**1.** A capacitive information carrier (1), **characterized in that** at least one electrically conductive layer is disposed at least in some areas as a touch structure (3) on an electrically non-conductive substrate (2), comprising

> a. at least two touch points and at least one conductor path (4)
> or
> b. at least one touch point, at least one coupling surface (5) and at least one conductor path (4),

wherein said touch point simulates the property of a finger tip, said coupling surface couples external capacities for increasing the effective electric capacity of said touch structure (3) and said conductor path (4) forms an electrical connection between two touch points or between a touch point and a coupling surface (5).

**2.** The capacitive information carrier (1) according to claim 1, manufactured using electrically conductive paint or ink, or manufactured by a transfer film method, wherein said transfer film method comprises the following steps:

> a. Providing a transfer film on a roll, wherein the transfer film comprises a carrier film and an electrically conductive transfer layer located thereon at least in some areas;
> b. Providing an electrically non-conductive substrate;
> c. Providing an adhesive;
> d. Applying the adhesive according to c) in a structured manner onto the substrate and/or the transfer film,
> e. Applying the transfer film in a structured manner onto the substrate (2),

wherein at least one electrically conductive layer is disposed at least in some areas on the electrically non-conductive substrate as a touch structure (3).

**3.** A method for manufacturing a capacitive information carrier (1), comprising the following steps:

> a. Providing a transfer film on a roll, wherein the transfer film comprises a carrier film and an electrically conductive transfer layer located thereon at least in some areas;
> b. Providing an electrically non-conductive substrate;

c. Providing an adhesive;

d. Applying the adhesive according to c) in a structured manner onto the substrate and/or the transfer film,

wherein at least one electrically conductive layer is disposed at least in some areas on the electrically non-conductive substrate as a touch structure (3), comprising

a. at least two touch points and at least one conductor path (4) or

b. at least one touch point, at least one coupling surface (5) and at least one conductor path (4),

wherein said touch point simulates the property of a finger tip, said coupling surface couples external capacities for increasing the effective electric capacity of said touch structure (3) and said conductor path (4) forms an electrical connection between two touch points or between a touch point and a coupling surface (5).

4. A capacitive information carrier (1) manufactured according to the method according to claim 3.

5. The capacitive information carrier (1) according to claim 1, 2, or 4,
**characterized in that**
at least one electrically conductive touch structure (3) that simulates the arrangement and/or properties of finger tips is disposed on an electrically non-conductive substrate (2).

6. The capacitive information carrier (1) according to claim 5,
**characterized in that**
the adhesive is an electrically conductive adhesive.

7. The capacitive information carrier (1) according to one or more of claims 1, 2, 4, 5, and/or 6,
**characterized in that**
at least the touch structure (3) is covered with another layer.

8. The capacitive information carrier (1) according to claim 7,
**characterized in that**
the other layer covering the touch structure (3) is a paper layer, a film layer, a paint layer, a varnish layer, and/or combinations thereof.

9. The capacitive information carrier (1) according to one or more of claims 1, 2, 4, 5, 6, 7, and/or 8,
**characterized in that**
it comprises at least one cover layer (6) completely or partially covering the substrate (2).

10. The capacitive information carrier (1) according to one or more of claims 1, 2, 4, 5, 6, 7, 8, and/or 9,
**characterized in that**
the information carrier (1) is connected to an article (7) or the article (7) itself serves as a substrate (2).

11. The capacitive information carrier (1) according to one or more of claims 1, 2, 4, 5, 6, 7, 8, 9, and/or 10,
**characterized in that**
the applied touch structure (3) can be altered in some areas in terms of its structuring using additive and/or subtractive methods, preferably using inkjet methods and particularly preferably using laser methods.

12. A system for acquiring information, comprising:

a. at least one capacitive information carrier (1) according to one or more of claims 1, 2, 4, 5, 6, 7, 8, 9, 10, and/or 11;

b. at least one capacitive area sensor (9);

wherein capacitive interaction is achieved by a static and/or dynamic contact between a. and b.

13. The system according to claim 12,
**characterized in that**
through the capacitive interaction, the touch structure (3) of the information carrier (1) becomes evaluable for a data processing system connected to the area sensor (9), and said data processing system can trigger events associated with the information carrier (1).

14. The system according to one of claims 12 or 13,
    **characterized in that**
    the area sensor (9) and/or a device (8) containing the area sensor comprises capacitive touch screens and/or touch pads and is selected from the group consisting of smartphones, cell phones, displays, tablet PCs, tablet notebooks, touch pad devices, graphics tablets, television sets, PDAs, MP3 players, track pads and capacitive input devices.

15. Use of a system according to one or more of claims 12, 13, and/or 14,
    **characterized in that**
    at least one information carrier (1) is in contact with at least one area sensor (9) at least in some areas.

16. Use of a system according to one or more of claims 12, 13, and/or 14,
    **characterized in that**
    the area sensor (9), in a movement relative to the information carrier (1), progressively receives complete or partial information from the information carrier (1).

17. Use of a system according to one or more of claims 12, 13, and/or 14,
    **characterized in that**
    multiple information carriers (1) are read in combination, particularly next to one another and/or one above the other and/or in chronological succession.

18. Use of a capacitive information carrier according to claim 1, 2, or 4 for acquiring information, comprising

    a. Providing the capacitive information carrier (1) and at least one capacitive area sensor (9);
    b. Bringing at least one information carrier (1) in contact with the at least one area sensor (9), wherein the contact can be static and/or dynamic, and
    c. Triggering a capacitive interaction between the area sensor (9) and the information carrier (1), wherein through the capacitive interaction, the touch structure (3) of the information carrier (1) becomes evaluable for a data processing system connected to the area sensor (9) and can trigger events associated with information carrier (1).

19. Use of at least one information carrier (1) for acquiring information according to claim 18,
    **characterized in that**
    the information carrier (1) is assigned to a dataset in the data processing system and the dataset remains constant.

20. Use of at least one information carrier (1) for acquiring information according to claim 18,
    **characterized in that**
    the information carrier (1) is assigned to a dataset in the data processing system and the dataset changes.

21. Use of at least one information carrier (1) for acquiring information according to one or several of claims 18, 19, and/or 20, **characterized in that**
    the information carrier (1) in connection with an area sensor (9) is assigned via the touch structure (3) to an action of a data processing system or triggers said action.

22. Use of at least one information carrier (1) for acquiring information according to one or several of claims 18, 19, 20, and/or 21, **characterized in that**
    at least two information carriers (1) are combined, and through the combination, an event is triggered.

**Revendications**

1. Support d'informations capacitif (1),
   **caractérisé en ce que**
   au moins une couche électroconductrice est agencée en tant que structure tactile (3) au moins par zone sur un substrat électriquement non conducteur (2) comprenant

   a. au moins deux points tactiles et au moins une piste conductrice (4)
   ou

b. au moins un point tactile, au moins une surface de couplage (5) et au moins une piste conductrice (4),

dans lequel le point tactile reproduit la propriété d'un bout de doigt, la surface de couplage accouple des capacités externes pour augmenter la capacité électrique efficace de la structure tactile (3) et la piste conductrice (4) forme une liaison électrique entre deux points tactiles ou entre un point tactile et une surface de couplage (5).

**2.** Support d'informations capacitif (1) selon la revendication 1 fabriqué en utilisant une peinture ou encre électroconductrice ou fabriqué par un procédé de film de transfert, dans lequel le procédé de film de transfert comprend les étapes suivantes :

a. mise à disposition d'un film de transfert sur un rouleau, dans lequel le film de transfert comprend un film de support et une couche de transfert électroconductrice se trouvant au moins par zone sur celui-ci,
b. mise à disposition d'un substrat électriquement non conducteur,
c. mise à disposition d'un adhésif,
d. application structurée de l'adhésif selon c) sur le substrat et/ou sur le film de transfert,
e. application structurée du film de transfert sur le substrat (2)

dans lequel une couche électroconductrice est agencée en tant que structure tactile (3) au moins par zone sur le substrat électriquement non conducteur.

**3.** Procédé de fabrication d'un support d'informations capacitif (1), comprenant les étapes suivantes :

a. mise à disposition d'un film de transfert sur un rouleau, dans lequel le film de transfert comprend un film de support et une couche de transfert électroconductrice se trouvant au moins par zone sur celui-ci,
b. mise à disposition d'un substrat électriquement non conducteur,
c. mise à disposition d'un adhésif,
d. application structurée de l'adhésif selon c) sur le substrat et/ou sur le film de transfert

dans lequel une couche électroconductrice est agencée en tant que structure tactile (3) au moins par zone sur le substrat électriquement non conducteur comprenant

a. au moins deux points tactiles et au moins une piste conductrice (4)
ou
b. au moins un point tactile, au moins une surface de couplage (5) et au moins une piste conductrice (4),

dans lequel le point tactile reproduit la propriété d'un bout de doigt, la surface de couplage accouple des capacités externes pour augmenter la capacité électrique efficace de la structure tactile (3) et la piste conductrice (4) forme une liaison électrique entre deux points tactiles ou entre un point tactile et une surface de couplage (5).

**4.** Support d'informations capacitif (1) fabriqué selon le procédé selon la revendication 3.

**5.** Support d'informations capacitif (1) selon la revendication 1, 2 ou 4,
**caractérisé en ce que**
au moins une structure tactile (3) électroconductrice, reproduisant l'agencement et/ou les propriétés de bouts de doigts est agencée sur un substrat électriquement non conducteur (2).

**6.** Support d'informations capacitif (1) selon la revendication 5,
**caractérisé en ce que**
l'adhésif est un adhésif électroconducteur.

**7.** Support d'informations capacitif (1) selon une ou plusieurs des revendications 1, 2, 4, 5 et/ou 6,
**caractérisé en ce que**
au moins la structure tactile (3) est couverte par une autre couche.

**8.** Support d'informations capacitif (1) selon la revendication 7,
**caractérisé en ce que**
l'autre couche couvrant la structure tactile (3) est une couche de papier, une couche de film, une couche de peinture, une couche de vernis et/ou des combinaisons de celles-ci.

9. Support d'informations capacitif (1) selon une ou plusieurs des revendications 1, 2, 4, 5, 6, 7 et/ou 8, **caractérisé en ce que** celui-ci présente au moins une couche couvrante (6) recouvrant entièrement ou en partie le substrat (2).

10. Support d'informations capacitif (1) selon une ou plusieurs des revendications 1, 2, 4, 5, 6, 7, 8 et/ou 9, **caractérisé en ce que** le support d'informations (1) est relié à un objet (7) ou l'objet (7) lui-même sert de substrat (2).

11. Support d'informations capacitif (1) selon une ou plusieurs des revendications 1, 2, 4, 5, 6, 7, 8, 9 et/ou 10, **caractérisé en ce que** la structure tactile (3) appliquée peut être modifiée par zone dans sa structuration au moyen de procédés additifs et/ou soustractifs, de préférence par procédé par jet d'encre et de manière particulièrement préférée par procédé laser.

12. Système pour détecter des informations, comprenant :

   a. au moins un support d'informations capacitif (1) selon une ou plusieurs des revendications 1, 2, 4, 5, 6, 7, 8, 9, 10 et/ou 11,
   b. au moins un capteur de surface capacitif (9),

   dans lequel une interaction capacitive est obtenue par un contact statique et/ou dynamique entre a. et b.

13. Système selon la revendication 12, **caractérisé en ce que** par l'interaction capacitive, la structure tactile (3) du support d'informations (1) peut être évaluée par un système de traitement de données relié au capteur de surface (9) et celui-ci peut déclencher des événements associés au support d'informations (1).

14. Système selon l'une quelconque des revendications 12 ou 13, **caractérisé en ce que** le capteur de surface (9) et/ou l'appareil (8) contenant le capteur de surface comprend des écrans tactiles et/ou pavés tactiles capacitifs et est sélectionné dans le groupe constitué de smartphones, téléphones portables, écrans, tablettes, ordinateurs portables, appareils à pavé tactile, tablettes graphiques, téléviseurs, assistants personnels, lecteurs MP3, pavés tactiles et appareils de saisie capacitifs.

15. Utilisation d'un système selon une ou plusieurs des revendications 12, 13 et/ou 14, **caractérisée en ce que** au moins un support d'informations (1) est en contact au moins par zone avec au moins un capteur de surface (9).

16. Utilisation d'un système selon une ou plusieurs des revendications 12, 13 et/ou 14, **caractérisée en ce que** le capteur de surface (9) reçoit dans un mouvement par rapport au support d'informations (1) progressivement entièrement ou en partie des informations du support d'informations (1).

17. Utilisation d'un système selon une ou plusieurs des revendications 12, 13 et/ou 14, **caractérisée en ce que** plusieurs supports d'information (1) sont lus en combinaison, en particulier l'un à côté de l'autre et/ou l'un au-dessus de l'autre et/ou temporellement l'un après l'autre.

18. Utilisation d'un support d'informations capacitif selon la revendication 1, 2 ou 4 pour détecter des informations, comprenant

   a. la mise à disposition du support d'informations capacitif (1) et d'au moins un capteur de surface capacitif(9),
   b. la mise en contact d'au moins un support d'informations (1) avec l'au moins un capteur de surface (9), dans lequel le contact peut être statique et/ou dynamique et
   c. le déclenchement d'une interaction capacitive entre le capteur de surface (9) et le support d'informations (1), dans laquelle par l'interaction capacitive, la structure tactile (3) du support d'informations (1) peut être évaluée par un système de traitement de données relié au capteur de surface (9) et peut déclencher des événements associés au support d'informations (1)

19. Utilisation d'au moins un support d'informations (1) pour détecter des informations selon la revendication 18, **caractérisée en ce que** le support d'informations (1) est affecté à un jeu de données dans un système de traitement de données et le jeu de données reste constant.

20. Utilisation d'au moins un support d'informations (1) pour détecter des informations selon la revendication 18, **caractérisée en ce que** le support d'informations (1) est affecté à un jeu de données dans un système de traitement de données et le jeu de données change.

21. Utilisation d'au moins un support d'informations (1) pour détecter des informations selon une ou plusieurs des revendications 18, 19 et/ou 20, **caractérisée en ce que** le support d'informations (1) est affecté à une action d'un système de traitement de données en association avec un capteur de surface (9) par le biais de la structure tactile (3) ou déclenche celle-ci.

22. Utilisation d'au moins un support d'informations (1) pour détecter des informations selon une ou plusieurs des revendications 18, 19, 20 et/ou 21, **caractérisée en ce que** au moins deux supports d'informations (1) sont combinés et un événement est déclenché par la combinaison.

Fig. 1

Fig. 2

Fig. 3

Fig. 4

Fig. 5a

Fig. 5b

Fig. 6

Fig. 7

Fig. 8

Fig. 9

Fig. 10

Fig. 11

Fig. 12a

Fig. 12b

Fig. 13

Fig. 14

Fig. 15

Fig. 16

Fig. 17

Fig. 18

Fig. 19

Fig. 20a

Fig. 20b

Fig. 20c

Fig. 21

Fig. 22

Fig. 23

Fig. 24

signierter
Informationsträger

Fig. 25

Datenverarbeitungssystem

entschlüsseln

Datenverarbeitungssystem

Software

Aktionen

Flächensensor

verschlüsselter
Informationsträger

Fig. 26

Fig. 27

Fig. 28

Fig. 29

Fig. 30

Fig. 31

Fig. 32

Fig. 33

Fig. 34

Fig. 35

A)

B)

Fig. 36

Fig. 37

Fig. 38

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3719804 A
- EP 1803562 A
- US 5818019 A
- US 4587410 A
- US 20060118612 A